(19) Europäisches Patentamt
European Patent Office
Office européen des brevets

(11) **EP 4 746 507 A1**

(12) **EUROPEAN PATENT APPLICATION**
published in accordance with Art. 153(4) EPC

(43) Date of publication:
**20.05.2026 Bulletin 2026/21**

(51) International Patent Classification (IPC):
***H04W 28/06*** (2009.01)

(21) Application number: **23949378.6**

(52) Cooperative Patent Classification (CPC):
**H04W 28/06**

(22) Date of filing: **22.08.2023**

(86) International application number:
**PCT/CN2023/114231**

(87) International publication number:
**WO 2025/039185 (27.02.2025 Gazette 2025/09)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• **DU, Yuqing
  Shenzhen, Guangdong 518129 (CN)**
• **MA, Mengyao
  Shenzhen, Guangdong 518129 (CN)**
• **YAN, Min
  Shenzhen, Guangdong 518129 (CN)**

(74) Representative: **Pfenning, Meinig & Partner mbB
Patent- und Rechtsanwälte
Theresienhöhe 11a
80339 München (DE)**

(54) **DATA COMPRESSION AND TRANSMISSION METHOD, AND APPARATUS, DEVICE AND STORAGE MEDIUM**

(57) This application provides a data compression and transmission method, an apparatus, a device, and a storage medium. The method includes: compressing to-be-compressed data to obtain first compressed information, where the first compressed information includes: first base information and first location indication information, or first base information, first coefficient information, and first location indication information, where the first base information includes M pieces of first data in the to-be-compressed data, the first coefficient information includes first coefficient sub-information respectively corresponding to N pieces of second data in the to-be-compressed data, the first coefficient sub-information of the second data includes an expression coefficient of at least one piece of first data in the M pieces of first data for the second data, and the first location indication information indicates locations of the M pieces of first data and/or locations of the N pieces of second data in the to-be-compressed data; and sending the first compressed information. The second data is expressed by using the first data in the to-be-compressed data, thereby implementing reliable and efficient data compression.

FIG. 3

## Description

## TECHNICAL FIELD

This application relates to the field of communication technologies, and in particular, to a data compression and transmission method, an apparatus, a device, and a storage medium.

## BACKGROUND

Currently, in some communication scenarios, for example, a point cloud data transmission scenario or an artificial intelligence (artificial intelligence, AI) model data (which is briefly referred to as AI model data below) transmission scenario, when data transmitted between communication devices is large, a large quantity of transmission resources are occupied, and a transmission delay may be increased. In view of this, before data transmission, to-be-transmitted data may be compressed, for example, data compression is performed in a scalar quantization manner or a vector quantization manner, and then compressed data is transmitted, to save transmission resources and reduce a transmission delay. However, in a current data compression solution, a compression ratio is low, and the compressed data has a large data loss. Therefore, how to implement effective and reliable data compression and transmission is an urgent problem to be resolved currently.

## SUMMARY

Embodiments of this application provide a data compression and transmission method, an apparatus, a device, and a storage medium, to implement effective and reliable data compression and transmission.

According to a first aspect, this application provides a data compression and transmission method. The method may be performed by a first communication apparatus. The first communication apparatus may be a terminal device or a component in a terminal device, or the first communication apparatus may be a network device or a component in a network device.

In the method, the first communication apparatus can compress to-be-compressed data to obtain first compressed information, where the first compressed information includes: first base information and first location indication information, or first base information, first coefficient information, and first location indication information, where the first base information includes M pieces of first data in the to-be-compressed data, M is a positive integer, the first coefficient information includes first coefficient sub-information respectively corresponding to N pieces of second data in the to-be-compressed data, N is a positive integer, the first coefficient sub-information of the second data includes an expression coefficient of at least one piece of first data in the M pieces of first data for the second data, and the first location indication information indicates locations of the M pieces of first data and/or locations of the N pieces of second data in the to-be-compressed data. Further, the first communication apparatus sends the first compressed information. In this embodiment of this application, in a data compression and transmission process, the second data is expressed by using the first data in the to-be-compressed data, and further the transmitted first compressed information includes the expression coefficient of the first data for the second data. Compared with transmission of the second data, this transmission implements reliable and efficient compression of the data. Especially when a data amount of the to-be-compressed data is large, a compression ratio and compression reliability can be effectively improved, thereby reducing communication overheads.

Optionally, the first coefficient sub-information of the second data further includes second location indication information, and the second location indication information indicates a location of at least one piece of first data expressing the second data in the M pieces of first data, so that a receive end can accurately construct the second data based on the second location indication information.

Optionally, in the first coefficient sub-information of the second data, the expression coefficient corresponds to one piece of first data that has a first capability of expressing corresponding second data, and the expression coefficient indicates an expression capability of the corresponding first data for the second data. Based on this, an expression coefficient corresponding to first data that does not have the first expression capability for the second data is not included in the first coefficient sub-information, thereby further improving compression efficiency.

In some embodiments, to improve data compression and transmission reliability, when transmission resources are limited, compression and transmission may be performed between the first communication apparatus and the second communication apparatus in an incremental transmission manner. For example, the first communication apparatus may send second compressed information, where the second compressed information may include the following several possible implementations:

> manner 1: The second compressed information includes second coefficient information, where the second coefficient information includes second coefficient sub-information respectively corresponding to the N pieces of second data, the second coefficient sub-information of the second data includes an expression coefficient of at least one piece of first data in the M pieces of first data for the second data, and an expression capability of the expression coefficient in the second coefficient sub-information for the second data is different from an expression capability of the expression coefficient in the corresponding first coefficient sub-information for the second data; or

manner 2: The second compressed information includes second coefficient information and third location indication information, where the second coefficient information includes second coefficient sub-information respectively corresponding to N' pieces of second data in the to-be-compressed data other than the N pieces of second data, N' is a positive integer, the second coefficient sub-information of the second data includes an expression coefficient of at least one piece of first data in the M pieces of first data for the second data, and the third location indication information indicates locations of the N' pieces of second data in the to-be-compressed data; or

manner 3: The second compressed information includes second base information and third location indication information, or second base information, second coefficient information, and third location indication information, where the second base information includes M' pieces of first data in the to-be-compressed data other than the M pieces of first data, M' is a positive integer, the second coefficient information includes second coefficient sub-information corresponding to the N pieces of second data and/or second coefficient sub-information corresponding to N' pieces of second data in the to-be-compressed data other than the N pieces of second data, the second coefficient sub-information of the second data includes an expression coefficient of at least one piece of first data in the M' pieces of first data for the second data, and the third location indication information indicates locations of the M' pieces of first data and/or locations of the N' pieces of second data in the to-be-compressed data; or

manner 4: The second compressed information includes second base information and third location indication information, or second base information, second coefficient information, and third location indication information, where the second base information includes M' pieces of first data in the to-be-compressed data other than the M pieces of first data, the second coefficient information includes second coefficient sub-information corresponding to the N pieces of second data and/or second coefficient sub-information corresponding to the N pieces of second data or N' pieces of second data in the to-be-compressed data other than the N pieces of second data, the second coefficient sub-information of the second data includes an expression coefficient of at least one piece of first data in the M pieces of first data and the M' pieces of first data for the second data, and the third location indication information indicates locations of the M' pieces of first data and/or locations of the N' pieces of second data in the to-be-compressed data.

The foregoing manner 1 to manner 4 may be applied to different incremental transmission scenarios. In the foregoing manner 1, the second compressed information sent in an incremental transmission phase occupies fewer bits, which can save transmission resources. In the foregoing manner 2, compression and transmission of more second data is implemented. In the foregoing manner 3, the second data is expressed based on first data different from that in an initial transmission phase, which improves a data expression capability and further improves accuracy of restoring the second data. In the foregoing manner 4, compression and transmission of more second data is implemented, and the second data is expressed based on a large amount of first data, which improves accuracy of expressing the second data, and provides a basis for accurately restoring the second data.

In some embodiments, the first communication apparatus determines the M pieces of first data based on a first parameter and/or a second parameter of each piece of data in the to-be-compressed data, where the first parameter indicates correlation between corresponding data and other data in the to-be-compressed data, and the second parameter indicates importance of the corresponding data. On one hand, data of high importance in the to-be-compressed data is used as the first data, so that the data of high importance is transmitted in a manner of a low compression ratio and high reliability. On the other hand, some data of low correlation in the to-be-compressed data is considered as the first data, so that expression coefficients of the first data for the second data may be sparser, thereby improving a compression ratio of the second data.

When the first communication apparatus determines the first data based on the first parameter, that is, correlation between the data in the to-be-compressed data, the first communication apparatus may determine, one by one, whether the data in the to-be-compressed data is the first data. For example, for any piece of data (for example, an $i^{th}$ piece of data) in the to-be-compressed data, the first communication apparatus may determine, based on correlation between current m' pieces of first data and the $i^{th}$ piece of data, whether the $i^{th}$ piece of data is first data, where m' is a positive integer less than M, and i is a positive integer.

In some embodiments, the first communication apparatus may determine the first coefficient sub-information of the second data in a process of determining the first data. The $i^{th}$ piece of data is used as an example. After determining that the $i^{th}$ piece of data is the second data, the first communication apparatus may perform data compression on the $i^{th}$ piece of data based on the m' pieces of first data, to obtain first coefficient sub-information of the $i^{th}$ piece of data. In this case, the first communication apparatus determines the first coefficient information more efficiently, and resource overheads of the first coefficient information are low.

In some other embodiments, the first communication apparatus may determine the first coefficient sub-information of the second data after determining the M pieces of first data. The $i^{th}$ piece of data is still used as an example. The first communication apparatus determines that the $i^{th}$ piece of data is the second data, and may perform data compression on the $i^{th}$ piece of data based on the M pieces of first data, to obtain first coefficient sub-information of the $i^{th}$ piece of data. In this case, first coefficient information that is of each piece of second data and that is determined by the first communication apparatus has a stronger expression capability, thereby providing a basis for accurately restoring the second data.

In some embodiments, to enable data of high importance to be transmitted in a manner of a low compression ratio and high reliability, the first communication apparatus may select the M pieces of first data in descending order of second parameters of data in the to-be-compressed data, where the second parameter indicates importance of corresponding data.

In some embodiments, the first communication apparatus may determine, in the to-be-compressed data in descending order of the second parameters, first M pieces of data having lowest first parameters, and use the M pieces of data as the M pieces of first data, where the second parameter indicates importance of corresponding data, and the first parameter indicates correlation between the corresponding data and other data in the to-be-compressed data. The M pieces of first data are comprehensively determined based on the importance of the data and the correlation between the data and the other data, so that a high data compression ratio is achieved while reliable transmission of the data of the high importance is ensured.

In some embodiments, the compressed information includes an importance level, and the importance level indicates a quantity of quantization bits of corresponding data. Different quantization bits are used for data of different importance levels, to ensure data compression reliability while improving a data compression ratio.

In some embodiments, because transmission resources are limited or resource overheads are reduced, large compressed data needs to be further compressed, to implement bit selection and reduction. For example, the following two possible implementations may be included.

Implementation 1: The first communication apparatus may determine the M pieces of first data from K pieces of first data in the to-be-compressed data based on a first parameter and/or a second parameter of each piece of first data in the K pieces of first data, where K is a positive integer greater than M, the first parameter indicates correlation between corresponding first data and other data in the to-be-compressed data, and the second parameter indicates importance of the corresponding first data.

Implementation 2: When a bit of the first compressed information is greater than a bit threshold, the first communication apparatus performs selection on the expression coefficient based on importance of each piece of first data in the at least one piece of first data and/or an expression capability for the second data, where a second parameter of first data corresponding to a selected expression coefficient is greater than or equal to an importance threshold, and/or the first data corresponding to the selected expression coefficient has a second capability of expressing the second data, the second capability is greater than the first capability, and the second parameter indicates importance of the corresponding first data.

In some embodiments, the first communication apparatus sends or receives first indication information, where the first indication information indicates an amount of first data, so that the first communication apparatus can determine, from the to-be-compressed data, the first data of the corresponding data.

In some embodiments, the first communication apparatus sends second indication information, where the second indication information indicates a value range of the first data, and the value range of the first data is used to determine a quantity of quantization bits of the first data, so that the first communication apparatus determines the quantity of quantization bits based on the value range.

In some embodiments, the first communication apparatus determines a total quantity of quantization bits of the to-be-compressed data based on a time-frequency resource, to ensure that the to-be-compressed data can be transmitted on the time-frequency resource after being compressed.

According to a second aspect, an embodiment of this application provides a data compression and transmission method. The method may be performed by a second communication apparatus. The second communication apparatus may be a terminal device or a component in a terminal device, or the second communication apparatus may be a network device or a component in a network device.

In the method, the second communication apparatus receives first compressed information, where the first compressed information includes: first base information and first location indication information, or first base information, first coefficient information, and first location indication information, where the first base information includes M pieces of first data in the to-be-compressed data, M is a positive integer, the first coefficient information includes first coefficient sub-information respectively corresponding to N pieces of second data in the to-be-compressed data, N is a positive integer, the first coefficient sub-information of the second data includes an expression coefficient of at least one piece of first data in the M pieces of first data for the second data, and the first location indication information indicates locations of the M pieces of first data and/or locations of the N pieces of second data in the to-be-compressed data; and the second communication apparatus decompresses the first compressed information to obtain first decompressed data, where the first decompressed data includes M pieces of first data obtained through restoration and N pieces of second data obtained through restoration.

In some embodiments, the coefficient sub-information of the second data further includes second location indication information, and the second location indication information indicates a location of at least one piece of first data expressing the second data in the M pieces of first data.

In some embodiments, the expression coefficient corresponds to one piece of first data that has a first capability of expressing corresponding second data, and the expression coefficient indicates an expression capability of the corresponding first data for the second data.

In some embodiments, the method further includes: The second communication apparatus receives second compressed information, and decompresses the second compressed information to obtain second decompressed data, where

the second compressed information includes: second coefficient information, where the second coefficient information includes second coefficient sub-information respectively corresponding to the N pieces of second data, the second coefficient sub-information of the second data includes an expression coefficient of at least one piece of first data in the M pieces of first data for the second data, and an expression capability of the expression coefficient in the second coefficient sub-information for the second data is different from an expression capability of the expression coefficient in the corresponding first coefficient sub-information for the second data; and the second decompressed data includes N pieces of second data obtained through re-restoration; or
the second compressed information includes: second coefficient information and third location indication information, where the second coefficient information includes second coefficient sub-information respectively corresponding to N' pieces of second data in the to-be-compressed data other than the N pieces of second data, N' is a positive integer, the second coefficient sub-information of the second data includes an expression coefficient of at least one piece of first data in the M pieces of first data for the second data, and the third location indication information indicates locations of the N' pieces of second data in the to-be-compressed data; and the second decompressed data includes N' pieces of second data obtained through restoration; or
the second compressed information includes: second base information and third location indication information, or second base information, second coefficient information, and third location indication information, where the second base information includes M' pieces of first data in the to-be-compressed data other than the M pieces of first data, M' is a positive integer, the second coefficient information includes second coefficient sub-information respectively corresponding to the N pieces of second data and/or second coefficient sub-information respectively corresponding to N' pieces of second data in the to-be-compressed data other than the N pieces of second data, the second coefficient sub-information of the second data includes an expression coefficient of at least one piece of first data in the M' pieces of first data for the second data, and the third location indication information indicates locations of the M' pieces of first data and/or locations of the N' pieces of second data in the to-be-compressed data; and the second decompressed data includes: M' pieces of first data obtained through restoration, and N pieces of second data obtained through re-restoration and/or N' pieces of second data obtained through restoration; or
the second compressed information includes: second base information and third location indication information, or second base information, second coefficient information, and third location indication information, where the second base information includes M' pieces of first data in the to-be-compressed data other than the M pieces of first data, the second coefficient information includes second coefficient sub-information respectively corresponding to the N pieces of second data and/or second coefficient sub-information respectively corresponding to N' pieces of second data in the to-be-compressed data other than the N pieces of second data, the second coefficient sub-information of the second data includes an expression coefficient of at least one piece of first data in the M pieces of first data and the M' pieces of first data for the second data, and the third location indication information indicates locations of the M' pieces of first data and/or locations of the N' pieces of second data in the to-be-compressed data; and the second decompressed data includes: M' pieces of first data obtained through restoration, and N pieces of second data obtained through re-restoration and/or N' pieces of second data obtained through restoration.

In some embodiments, that the second communication apparatus decompresses the first compressed information to obtain the first decompressed data includes: The second communication apparatus restores the M pieces of first data based on the first location indication information and base information; and restores the N pieces of second data based on the M pieces of first data obtained through restoration, the first coefficient information, and the second location indication information, where the second location indication information indicates the location of the at least one piece of first data that expresses the second data in the M

pieces of first data.

In some embodiments, the compressed information includes an importance level, and the importance level indicates a quantity of quantization bits of corresponding data.

According to a third aspect, an embodiment of this application provides a communication apparatus, including a processing module, configured to compress to-be-compressed data to obtain first compressed information, where the first compressed information includes: first base information and first location indication information, or first base information, first coefficient information, and first location indication information, where the first base information includes M pieces of first data in the to-be-compressed data, M is a positive integer, the first coefficient information includes first coefficient sub-information respectively corresponding to N pieces of second data in the to-be-compressed data, N is a positive integer, the first coefficient sub-information of the second data includes an expression coefficient of at least one piece of first data in the M pieces of first data for the second data, and the first location indication information indicates locations of the M pieces of first data and/or locations of the N pieces of second data in the to-be-compressed data; and a transceiver module, configured to send the first compressed information.

In a possible implementation, the first coefficient sub-information of the second data further includes second location indication information, and the second location indication information indicates a location of at least one piece of first data expressing the second data in the M pieces of first data.

In a possible implementation, the expression coefficient corresponds to one piece of first data that has a first capability of expressing corresponding second data, and the expression coefficient indicates an expression capability of the corresponding first data for the second data.

In a possible implementation, the transceiver module is further configured to send second compressed information, where the second compressed information includes: second coefficient information, where the second coefficient information includes second coefficient sub-information respectively corresponding to the N pieces of second data, the second coefficient sub-information of the second data includes an expression coefficient of at least one piece of first data in the M pieces of first data for the second data, and an expression capability of the expression coefficient in the second coefficient sub-information for the second data is different from an expression capability of the expression coefficient in the corresponding first coefficient sub-information for the second data; or second coefficient information and third location indication information, where the second coefficient information includes second coefficient sub-information respectively corresponding to N' pieces of second data in the to-be-compressed data other than the N pieces of second data, N' is a positive integer, the second coefficient sub-information of the second data includes an expression coefficient of at least one piece of first data in the M pieces of first data for the second data, and the third location indication information indicates locations of the N' pieces of second data in the to-be-compressed data; or second base information and third location indication information, or second base information, second coefficient information, and third location indication information, where the second base information includes M' pieces of first data in the to-be-compressed data other than the M pieces of first data, M' is a positive integer, the second coefficient information includes second coefficient sub-information corresponding to the N pieces of second data and/or second coefficient sub-information corresponding to N' pieces of second data in the to-be-compressed data other than the N pieces of second data, the second coefficient sub-information of the second data includes an expression coefficient of at least one piece of first data in the M' pieces of first data for the second data, and the third location indication information indicates locations of the M' pieces of first data and/or locations of the N' pieces of second data in the to-be-compressed data; or second base information and third location indication information, or second base information, second coefficient information, and third location indication information, where the second base information includes M' pieces of first data in the to-be-compressed data other than the M pieces of first data, the second coefficient information includes second coefficient sub-information corresponding to the N pieces of second data and/or second coefficient sub-information corresponding to N' pieces of second data in the to-be-compressed data other than the N pieces of second data, the second coefficient sub-information of the second data includes an expression coefficient of at least one piece of first data in the M pieces of first data and the M' pieces of first data for the second data, and the third location indication information indicates locations of the M' pieces of first data and/or locations of the N' pieces of second data in the to-be-compressed data.

In a possible implementation, the processing module is further configured to determine the M pieces of first data based on a first parameter and/or a second parameter of each piece of data in the to-be-compressed data, where the first parameter indicates correlation between corresponding data and other data in the to-be-compressed data, and the second parameter indicates importance of the corresponding data.

In a possible implementation, the processing module is further configured to determine, based on correlation between current m' pieces of first data and an $i^{th}$ piece of data in the compressed data, whether the $i^{th}$ piece of data is first data, where m' is a positive integer less than M, and i is a positive integer.

In a possible implementation, the processing module is further configured to: when the $i^{th}$ piece of data in the to-be-compressed data is second data, perform data compression on the $i^{th}$ piece of data based on the current m' pieces of first data; or when the $i^{th}$ piece of data in the to-be-compressed data is second data, perform data compression on the $i^{th}$ piece of data based on the M pieces of first data.

In a possible implementation, the processing module is further configured to select the M pieces of first data in descending order of second parameters of data in the to-be-compressed data, where the second parameter indicates importance of corresponding data.

In a possible implementation, the processing module is further configured to: determine, in the to-be-compressed data in descending order of the second parameters, first M pieces of data having lowest first parameters, and use the M pieces of data as the M pieces of first data, where the second parameter indicates importance of corresponding data, and the first parameter indicates correlation between the corresponding data and other data in the to-be-compressed data.

In a possible implementation, the compressed information includes an importance level, and the importance level indicates a quantity of quantization bits of corresponding data.

In a possible implementation, the processing module is further configured to determine the M pieces of first data from K pieces of first data in the to-be-compressed data based on a first parameter and/or a second parameter of each piece of first data in the K pieces of first data, where K is a positive integer greater than M, the first parameter indicates correlation between corresponding first data and other data in the to-be-compressed data, and the second parameter indicates importance of the corresponding first data.

In a possible implementation, the expression coefficient corresponds to one piece of first data that is in the at least one piece of first data and that has a first capability of expressing corresponding second data, and the expression coefficient indicates an expression capability of the corresponding first data for the second data; and the processing module is further configured to: when a bit of the first compressed information is greater than a bit threshold, performing selection on the expression coefficient based on importance of each piece of first data in the at least one piece of first data an expression capability for the second data, where a second parameter of first data corresponding to a selected expression coefficient is greater than or equal to an importance threshold, and/or the first data corresponding to the selected expression coefficient has a second capability of expressing the second data, the second capability is greater than the first capability, and the second parameter indicates importance of the corresponding first data.

In a possible implementation, the transceiver module is further configured to send or receive first indication information, where the first indication information indicates an amount of first data.

In a possible implementation, the transceiver module is further configured to send second indication information, where the second indication information indicates a value range of the first data, and the value range of the first data is used to determine a quantity of quantization bits of the first data.

In a possible implementation, the processing module is further configured to determine a total quantity of quantization bits of the to-be-compressed data based on a time-frequency resource.

According to a fourth aspect, an embodiment of this application provides a communication apparatus, including a transceiver module, configured to receive first compressed information, where the first compressed information includes: first base information and first location indication information, or first base information, first coefficient information, and first location indication information, where the first base information includes M pieces of first data in the to-be-compressed data, M is a positive integer, the first coefficient information includes first coefficient sub-information respectively corresponding to N pieces of second data in the to-be-compressed data, N is a positive integer, the first coefficient sub-information of the second data includes an expression coefficient of at least one piece of first data in the M pieces of first data for the second data, and the first location indication information indicates locations of the M pieces of first data and/or locations of the N pieces of second data in the to-be-compressed data; and the processing module is configured to decompress the first compressed information to obtain first decompressed data, where the first decompressed data includes M pieces of first data obtained through restoration and N pieces of second data obtained through restoration.

In a possible implementation, the coefficient sub-information of the second data further includes second location indication information, and the second location indication information indicates a location of at least one piece of first data expressing the second data in the M pieces of first data.

In a possible implementation, the expression coefficient corresponds to one piece of first data that has a first capability of expressing corresponding second data, and the expression coefficient indicates an expression capability of the corresponding first data for the second data.

In a possible implementation, the transceiver module is further configured to: receive second compressed information; and decompress the second compressed information to obtain second decompressed data, where the second compressed information includes: second coefficient information, where the second coefficient information includes second coefficient sub-information respectively corresponding to the N pieces of second data, the second coefficient sub-information of the second data includes an expression coefficient of at least one piece of first data in the M pieces of first data for the second data, and an expression capability of the expression coefficient in the second coefficient sub-information for the second data is different from an expression capability of the expression coefficient in the corresponding first coefficient sub-information for the second data; and the second decompressed data includes N pieces of second data obtained through re-restoration; or the second compressed information includes: second coefficient information and third location indication information, where the second coefficient information includes second coefficient sub-information respectively corresponding to N' pieces of second data in the to-be-compressed data other than the N pieces of second data, N' is a positive integer, the second coefficient sub-information of the second data includes an expression coefficient of at least one piece of first data in the M pieces of first data for the second data, and the third location indication information indicates locations of the N' pieces of second data in the to-be-compressed data; and the second decompressed data includes N' pieces of second data obtained through restoration; or the second compressed information includes: second base information and third location indication information, or second base information, second coefficient information, and third location indication information, where the second base information includes M' pieces of first data in the to-be-compressed data other than the M pieces of first data, M' is a positive integer, the second coefficient information includes second coefficient sub-information respectively corresponding to the N pieces of second data and/or second coefficient sub-information respectively corresponding to N' pieces of second data in the to-be-compressed data other than the N pieces of second data, the second coefficient sub-information of the second data includes an expression coefficient of at least one piece of first data in the M' pieces of first data for the second data, and the third location indication information indicates locations of the M' pieces of first data and/or locations of the N' pieces of second data in the to-be-compressed data; and the second decompressed data includes: M' pieces of first data obtained through restoration, and N pieces of second data obtained through re-restoration and/or N' pieces of second data obtained through restoration; or the second compressed information includes: second base information and third location indication information, or second base information, second coefficient information, and third location indication information, where the second base information includes M' pieces of first data in the to-be-compressed data other than the M pieces of first data, the second coefficient information includes second coefficient sub-information respectively corresponding to the N pieces of second data and/or second coefficient sub-information respectively corresponding to N' pieces of second data in the to-be-compressed data other than the N pieces of second data, the second coefficient sub-information of the second data includes an expression coefficient of at least one piece of first data in the M pieces of first data and the M' pieces of first data for the second data, and the third location indication information indicates locations of the M' pieces of first data and/or locations of the N' pieces of second data in the to-be-compressed data; and the second decompressed data includes: M' pieces of first data obtained through restoration, and N pieces of second data obtained through re-restoration and/or N' pieces of second data obtained through restoration.

In a possible implementation, the processing module is specifically configured to: restore the M pieces of first data based on the first location indication information and base information; and restore the N pieces of second data based on the M pieces of first data obtained through restoration, the first coefficient information, and the second location indication information, where the second location indication information indicates the location of the at least one piece of first data that expresses the second data in the M pieces of first data.

In a possible implementation, the compressed information includes an importance level, and the importance level indicates a quantity of quantization bits of corresponding data.

According to a fifth aspect, an embodiment of this application provides a communication device, including: a processor, configured to perform the method in any one of the first aspect, the second aspect, or the possible implementations of the first aspect and the second aspect via a computer program or using a logic circuit.

In a possible implementation, the communication apparatus further includes a memory, and the memory is configured to store the computer program.

In a possible implementation, the communication apparatus further includes a communication interface, and the communication interface is configured to input and/or output a signal.

According to a sixth aspect, an embodiment of this application provides a chip, including a processor. The processor is configured to: invoke computer instructions from a memory and run the computer instructions, to enable a device in which the chip is installed to perform the method according to the first aspect, the second aspect, or the possible implementations.

According to a seventh aspect, an embodiment of this application provides a communication system, including: a first communication apparatus, configured to perform the method in any one of the first aspect or the possible implementations of the first aspect; and a second communication apparatus, configured to perform the method in any one of the second aspect or the possible implementations of the second aspect.

According to an eighth aspect, an embodiment of this application provides a computer-readable storage medium, configured to store computer program instructions. The computer program enables a computer to perform the method in any one of the first aspect, the second aspect, or the possible implementations of the first aspect and the second aspect.

According to a ninth aspect, an embodiment of this application provides a computer program. The computer program enables a computer to perform the method in any one of the first aspect, the second aspect, or the possible implementations of the first aspect and the second aspect.

According to a tenth aspect, an embodiment of this application provides a computer program product, including computer program instructions. The computer program instructions enable a computer to perform the method in any one of the first aspect, the second aspect, or the possible implementations of the first aspect and the second aspect.

For beneficial effect of the content in the second aspect to the tenth aspect and the possible implementations, refer to the beneficial effect brought by the first aspect and the possible implementations of the first aspect. Details are not described herein again.

**BRIEF DESCRIPTION OF DRAWINGS**

FIG. 1 is a diagram of an architecture of a mobile communication system to which embodiments of this application are applied;

FIG. 2 is a diagram of an application scenario according to this application;

FIG. 3 is a schematic interaction flowchart of a data compression and transmission method according to an embodiment of this application;

FIG. 4 is a diagram of a structure of to-be-compressed data according to an embodiment of this application;

FIG. 5 is a diagram of data compression according to an embodiment of this application;

FIG. 6 is a schematic interaction flowchart of a data compression and transmission method according to an embodiment of this application;

FIG. 7a is a block diagram of one type of compressed information according to an embodiment of this application;

FIG. 7b is a block diagram of another type of compressed information according to an embodiment of this application;

FIG. 8a is a diagram of packet assembly according to an embodiment of this application;

FIG. 8b is a diagram of another packet assembly according to an embodiment of this application;

FIG. 9 is a block diagram of a communication apparatus according to an embodiment of this application; and

FIG. 10 is another block diagram of a communication apparatus according to an embodiment of this application.

**DESCRIPTION OF EMBODIMENTS**

The following describes technical solutions of this application with reference to accompanying drawings.

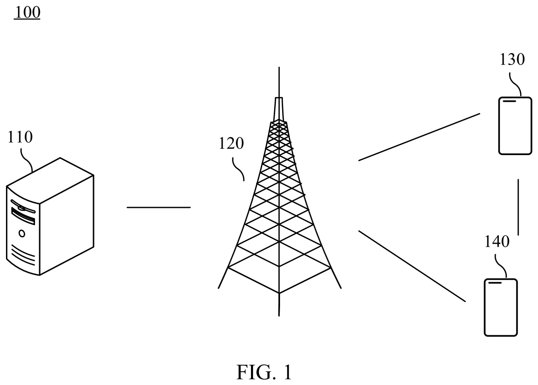

FIG. 1 is a diagram of an architecture of a mobile communication system to which embodiments of this application are applied. As shown in FIG. 1, the mobile communication system includes a core network device 110, a network device 120, and at least one terminal device (a terminal device 130 and a terminal device 140 shown in FIG. 1). The terminal device is connected to the network device in a wireless manner, and the network device is connected to the core network device in a wireless or wired manner. The core network device and the network device may be different physical devices independent of each other; functions of the core network device and logical functions of the network device may be integrated into a same physical device; or some functions of the core network device and some functions of the network device may be integrated into one physical device. The terminal device may be located at a fixed location, or may be mobile. FIG. 1 is only a diagram. The communication system may further include other network devices, for example, may further include a wireless relay device and a wireless backhaul device. This is not shown in FIG. 1. Quantities of core network devices, network devices, and terminal devices included in the mobile communication system are not limited in embodiments of this application.

In embodiments of this application, the network device may be any device having a wireless transceiver function. The network device includes but is not limited to: an evolved NodeB (evolved NodeB, eNB), a home NodeB (for example, a home evolved NodeB, or a home NodeB, HNB), a baseband unit (baseband unit, BBU), an access point (access point, AP) in a wireless fidelity (wireless fidelity, Wi-Fi) system, a wireless relay node, a wireless backhaul node, a transmission point (transmission point, TP), or a transmission and reception point (transmission and reception point, TRP), may be a mobile switching center, a device that undertakes functions of a base station in device-to-device (Device-to-Device, D2D), vehicle-to-everything (vehicle-to-everything, V2X), machine-to-machine (machine-to-machine, M2M) communication, and uncrewed aerial vehicle communication, and a network device (which may be deployed on a high-altitude platform, a satellite, or a high-altitude aircraft) in a non-terrestrial network (non-terrestrial network, NTN) communication system, may be a gNB in a 5G system or one or a group of antenna panels (including a plurality of antenna panels) of a base station in a 5G system, or may be a network node that forms a gNB or a transmission point, for example, a BBU or a distributed unit (distributed unit, DU). This is not specifically limited in embodiments of this application.

In some deployments, a gNB may include a central unit (central unit, CU) and a DU. The CU and the DU each implement some functions of the gNB, and the CU and the DU may communicate with each other through an F1 interface. The gNB may further include an active antenna unit (active antenna unit, AAU). The AAU may implement some physical layer processing functions, radio frequency processing, and a function related to an active antenna.

It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application.

In embodiments of this application, the terminal device may also be referred to as user equipment (user equipment, UE), an access terminal, a subscriber unit, a subscriber station, a mobile station, a mobile console, a remote station, a remote terminal, a mobile device, a user terminal, a terminal, a wireless communication device, a user agent, or a user apparatus.

The terminal device may be a device that provides voice/data connectivity for a user, for example, a handheld device or a vehicle-mounted device that has a wireless connection function. Currently, some examples of the terminal may be a mobile phone (mobile phone), a tablet computer (pad), a computer (for example, a notebook computer or a palmtop computer) with a wireless transceiver function, an uncrewed aerial vehicle, customer-premises equipment (customer-premises equipment, CPE), a point of sale (point of sale, POS) machine, a mobile internet device (mobile internet device, MID), a virtual reality (virtual reality, VR) device, an augmented reality (augmented reality, AR) device, a wireless terminal in industrial control (industrial control), a wireless terminal in self driving (self driving), a wireless terminal in telemedicine (remote medical), a wireless terminal in smart grid (smart grid), a wireless terminal in transportation safety (transportation safety), a wireless terminal in smart city (smart city), a wireless terminal in smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device, another processing device connected to a wireless modem, a vehicle-mounted device, a wearable device, a terminal device in a 5G network, a terminal device in a system evolved after 5G, or the like.

Communication between the network device and the terminal device may be performed over a licensed spectrum (licensed spectrum), or may be performed over an unlicensed spectrum (unlicensed spectrum), or may be performed over both a licensed spectrum and an unlicensed spectrum. The network device and the terminal device may communicate with each other on a spectrum below 6G, may communicate with each other on a spectrum above 6G, or may communicate with each other on both a spectrum below 6G and a spectrum above 6G. A spectrum resource used between the network device and the terminal device is not limited in embodiments of this application.

It should be understood that specific forms of the network device and the terminal device are not limited in this application.

A communication method provided in this application may be applied to various communication systems, for example, a long term evolution (Long Term Evolution, LTE) system, a 5G mobile communication system, and a mobile communication system evolved after the 5G mobile communication system, for example, a 6G mobile communication system. The 5G mobile communication system or the 6G mobile communication system may include non-standalone (non-standalone, NSA) and/or standalone (standalone, SA) networking.

The communication method provided in this application may be further applied to machine type communication (machine type communication, MTC), a long term evolution-machine technology (Long Term Evolution-machine, LTE-M), a device-to-device (device-to-device, D2D) network, a machine-to-machine (machine-to-machine, M2M) network, an internet of things (internet of things, IoT) network, or another network.

In some communication scenarios, a process of transmitting a large amount of data collected by a user terminal to a cloud is involved. For example, in an AI scenario, a user terminal sends AI model data to a cloud, and the cloud implements an AI task based on the AI model data sent by the user terminal. For another example, in a point cloud scenario, a user terminal sends, to a cloud, point cloud data collected by a sensor (sensor), and the cloud reconstructs data based on the point cloud data.

The user terminal may be implemented as 130 and/or 140 in FIG. 1, and the cloud may be implemented as a network device, for example, 120 in FIG. 1. However, a data transmission direction is not limited in this application. For example, a network device (for example, 120 in FIG. 1) may also send AI data or point cloud data to a user terminal (for example, 130 and/or 140 in FIG. 1). For another example, a user terminal (for example, 130 in FIG. 1) may send AI data or point cloud data to another user terminal (for example, 140 in FIG. 1). For ease of description, in the following, a data transmit end is referred to as a first communication apparatus, and a data receive end is referred to as a second communication apparatus.

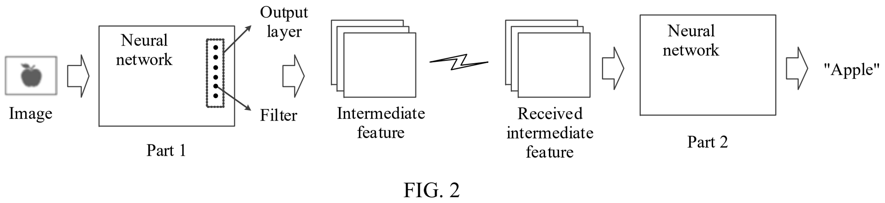

The following describes, with reference to FIG. 2, the transmitted AI model data as an example by using an AI-slit (AI-slit) scenario as an example.

As shown in FIG. 2, a neural network model is split into two parts, for example, a part (part) 1 and a part 2. The part 1 of the neural network model is deployed in the first communication apparatus, and the part 2 of the neural network model is deployed in the second communication apparatus. An example in which an image is recognized by using the neural network model is used. A first device inputs a to-be-recognized image into the part 1 of the neural network model, and an output layer (layer) of the part 1 of the neural network model correspondingly outputs one intermediate feature (feature map) via each filter (filter). Then, the first device sends these intermediate features (feature maps) to a second device. The second device inputs the received intermediate features (feature maps) into the part 2 of the neural network model, to obtain a recognition result of the image, for example, "apple".

A data amount of the point cloud data and a data amount of the AI model data are large. Currently, there is no effective and reliable compression and transmission solution for communication scenarios in which a large amount of data is transmitted, for example, a point cloud scenario and an AI scenario. To implement effective and reliable data compression and transmission, in embodiments of this application, other data is expressed based on some data in to-be-transmitted data, to implement effective and reliable data compression on to-be-transmitted data with a large data amount.

The following describes the communication method provided in embodiments of this application with reference to the accompanying drawings.

It should be understood that, merely for ease of understanding and description, the following describes the method provided in embodiments of this application by using interaction between a first communication apparatus and a second communication apparatus as an example. When a data compression and transmission method provided in embodiments of this application is applied to uplink transmission, the first communication apparatus may be any terminal device in the communication system shown in FIG. 1, for example, the terminal device 130 or the terminal device 140, and the second communication apparatus may be the network device 120 in the communication system shown in FIG. 1. When the data compression and transmission method provided in embodiments of this application is applied to downlink transmission, the first communication apparatus may be the network device 120 in the communication system shown in FIG. 1, and the second communication apparatus may be any terminal device in the communication system shown in FIG. 1, for example, the terminal device 130 or the terminal device 140. When the data compression and transmission method provided in embodiments of this application is applied to sidelink transmission, the first communication apparatus may be any terminal device in the communication system shown in FIG. 1, for example, the terminal device 130, and the second communication apparatus may be any terminal device other than the first communication apparatus in the communication system shown in FIG. 1, for example, the terminal device 140.

It should be further understood that this should not constitute any limitation on an execution entity of the method provided in this application. Any apparatus may serve as the execution entity of the method provided in embodiments of this application, provided that the apparatus can perform the method provided in embodiments of this application by running a program that includes code of the method provided in embodiments of this application. For example, any one of the foregoing communication apparatuses may be implemented as a terminal device, or may be implemented as a component in a terminal device, for example, a chip, a chip system, or another functional module that can invoke a program and execute the program. Any one of the foregoing communication apparatuses may be implemented as a network device, or may be implemented as a component in a network device, for example, a chip, a chip system, or another functional module that can invoke a program and execute the program.

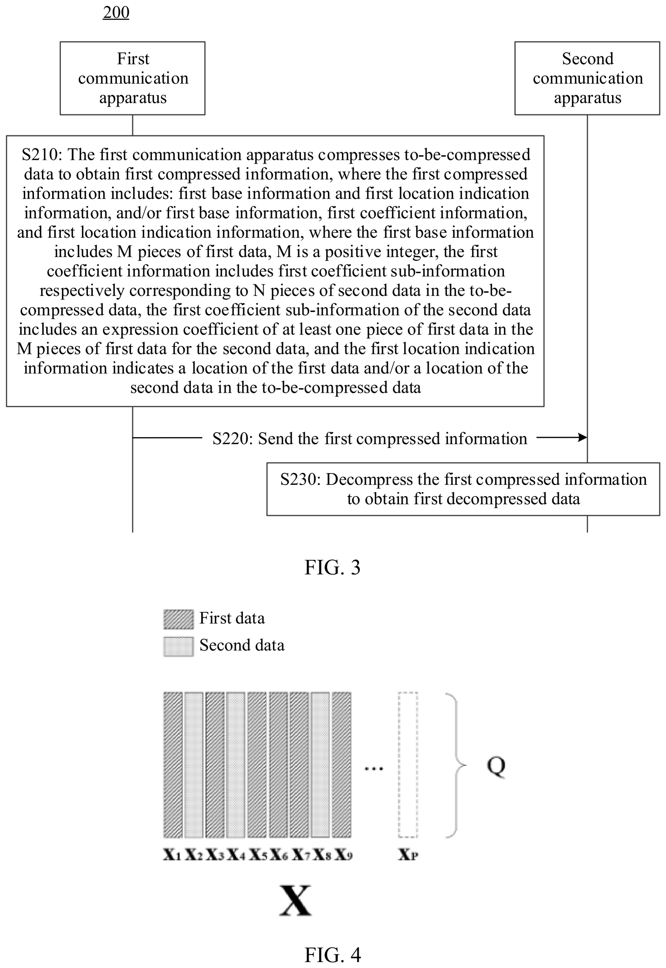

FIG. 3 is a schematic interaction flowchart of a data compression and transmission method according to an embodiment of this application. With reference to FIG. 3, a method 200 includes a part or all of the following processes.

S210: A first communication apparatus compresses to-be-compressed data to obtain first compressed information, where the first compressed information includes: first base information and first location indication information, and/or first base information, first coefficient information, and first location indication information, where the first base information includes M pieces of first data, M is a positive integer, the first coefficient information includes first coefficient sub-information respectively corresponding to N pieces of second data in the to-be-compressed data, the first coefficient sub-information of the second data includes an expression coefficient of at least one piece of first data in the M pieces of first data for the second data, and the first location indication information indicates a location of the first data and/or a location of the second data in the to-be-compressed data.

S220: The first communication apparatus sends the first compressed information to a second communication apparatus, and correspondingly, the second communication apparatus receives the first compressed information sent by the first communication apparatus.

S230: The second communication apparatus decompresses the first compressed information to obtain first decompressed data.

When data needs to be transmitted, the first communication apparatus performs data compression on the to-be-transmitted data and then transmits the to-be-transmitted data. Therefore, the to-be-compressed data may also be referred to as the to-be-transmitted data. The to-be-compressed data may include a plurality of pieces of data. The following describes the data as an example with reference to an AI-split scenario and a point cloud scenario.

In the foregoing AI-split scenario, an intermediate feature (feature map) output by one filter at a neural network layer may be considered as one piece of data. The plurality of pieces of data in the to-be-compressed data may be intermediate features (feature maps) respectively output by a plurality of filters. The plurality of filters may belong to a same neural network layer, or belong to different neural network layers. When the plurality of filters belong to at least two different neural network layers, the at least two network layers may be network layers with similar network structures, or may be network layers deployed at adjacent locations. Alternatively, an intermediate feature (feature map) output by one neural network layer is one piece of data, and the plurality of pieces of data in the to-be-compressed data may be intermediate features (feature maps) respectively output by a plurality of neural network layers.

In the point cloud scenario, each spatial point in a collection range includes three-dimensional coordinates, and may further include color information (RGB), location information, reflection intensity (intensity) information, and the like. The three-dimensional coordinates of the spatial point may be one piece of data, and coordinates of all or a part of spatial points collected at a same moment may form the to-be-compressed data.

The plurality of pieces of data in the to-be-compressed data may be correlated. When the plurality of pieces of data are correlated, some other data can be better expressed by using some of the plurality of pieces of data. In other words, when some other data is expressed by using some of the plurality of pieces of data, sparseness of expression coefficients is better, that is, compression efficiency is higher.

In the foregoing example, data that is in the to-be-compressed data and that may be used to express other data may be referred to as the first data, or may be referred to as base (base) information, and data that is expressed in the to-be-compressed data may be referred to as the second data. The M pieces of first data and the N pieces of second data may be all data in the to-be-compressed data, or in addition to the M pieces of first data and the N pieces of second data, the to-be-compressed data may further include other data. The other data in the to-be-compressed data may include the first data and/or the second data, or the to-be-compressed data may further include third data. Generally, the third data is inconvenient for expressing the other data, and is inconvenient for being well or effectively expressed by the other data. The other data in the to-be-compressed data may be compressed and transmitted in a manner of the first data, or may be compressed and transmitted in a manner of the second data, or the other data in the to-be-compressed data may be transmitted in any other manner. This is not limited in this application.

In the to-be-compressed data, lengths of all pieces of data may be the same. If sources of the data cause different lengths of original data, data processing may be performed on the original data, for example, value normalization, data dimension reduction, or data truncation, so that lengths of data obtained through data processing are the same.

The to-be-compressed data may be a matrix, or the to-be-compressed data may be expressed by using a matrix. Refer to FIG. 4. The to-be-compressed data may be a matrix X including P pieces of data, each piece of data may be used as a column vector in the matrix, and lengths of the data are all Q. 1st, 3rd, 5th, 6th, 7th, 9th, ... column vectors are the first data, and a column vector other than the first data may be the second data.

In some embodiments, the quantity Q of rows in the to-be-compressed data needs to be greater than the quantity P of columns. In this case, compared with transmitting the second data, expressing the second data by using the first data in the to-be-compressed data has better compression efficiency. If each piece of data in the to-be-compressed data has a large data amount and a quantity of pieces of data is small, the formed matrix X in FIG. 4 meets that P is less than Q. If each piece of data in the to-be-compressed data has a small data amount and a quantity of pieces of data is large, and the matrix X formed in FIG. 4 cannot meet that P is less than Q, row-column conversion may be performed on the matrix, to obtain a matrix whose quantity of rows is greater than quantity of columns. Then, a part of column vectors in the converted matrix is used as the first data, and the other part of column vectors is used as the second data. P and Q are both positive integers.

In a first example, the first compressed information obtained by compressing the to-be-compressed data by the first communication apparatus may include the first base information and the first location indication information. The first base information may include the foregoing M pieces of first data. The first location indication information may indicate, in the to-be-compressed data, locations of the M pieces of first data in the to-be-compressed data. The first location indication information may include a bitmap (bitmap), a location index, and the like. This is not limited in this application.

An example in which the first location indication information is a bitmap is used. A bit in the bitmap one-to-one corresponds to each piece of data in the to-be-compressed data. The bit in the bitmap indicates whether corresponding data in the to-be-compressed data is the first data. For example, when the bit in the bitmap is 1, it indicates that the corresponding data in the to-be-compressed data is the first data; or when the bit in the bitmap is 0, it indicates that the corresponding data in the to-be-compressed data is not the first data. Refer to FIG. 4. The to-be-compressed data is the matrix X, the M pieces of first data are the 1st, 3rd, 5 th, 6th, 7th, 9th, ... column vectors in the matrix X, and the first indication information may be [1, 0, 1, 0, 1, 1, 1, 0, 1, ...]. Certainly, this is not limited in this application. For example, when the bit in the bitmap is 0, it indicates that the corresponding data in the to-be-compressed data is the first data; or when the bit in the bitmap is 1, it indicates that the corresponding data in the to-be-compressed data is not the first data.

An example in which the first location indication information includes a location index is used. The first location indication information may include M location indexes, and each location index indicates a location of one piece of first data in the to-be-compressed data. Refer to FIG. 4. For example, a location index 1 indicates that a 1st column vector in the matrix X is the first data, a location index 2 indicates that a $3^{rd}$ column vector in the matrix X is the first data, a location index 3 indicates that a $5^{th}$ column vector in the matrix X is the first data, and a location index 4 indicates that a $6^{th}$ column vector in the matrix X is the first data.

In a second example, the first compressed information obtained by compressing the to-be-compressed data by the first communication apparatus may include the first base information, the first coefficient information, and the first location indication information. The first base information and the first location indication information are as described above. In this example, the first location indication information may indicate the first data in the to-be-compressed data, for example, indicate the M pieces of first data; or the first location indication information may indicate the N pieces of second data in the to-be-compressed data. A manner in which the first location indication information indicates the second data is similar to the manner in which the first data is indicated. For brevity, details are not described again. Alternatively, the first location indication information may indicate the first data and the second data in the to-be-compressed data. An example in which the first location indication information includes a bitmap is used. When a bit in the bitmap is 1, it indicates that corresponding data in the to-be-compressed data is the first data; or when a bit in the bitmap is 0, it indicates that corresponding data in the to-be-compressed data is second data.

Optionally, the first location indication information may be independent of the first base information and/or the first coefficient information, or the first location indication information may belong to the first base information or the first coefficient information.

The first coefficient information may include first coefficient sub-information corresponding to each piece of second data in at least one piece of second data, or in other words, first coefficient sub-information corresponding to each piece of second data in at least one piece of second data forms the first coefficient information. For the first coefficient sub-information corresponding to each piece of second data, the first coefficient sub-information may include an expression coefficient of at least one piece of first data in the M pieces of first data for the second data, and the at least one piece of first data may be a part or all of first data in the M pieces of first data.

The M pieces of first data may be all or a part of the first data that expresses the N pieces of second data that are expressed by the first coefficient information. When the M pieces of first data are a part of the first data that expresses the N pieces of second data that are expressed by the first coefficient information, the M pieces of first data may be a part of the first data in the to-be-compressed data; or when the M pieces of first data are all of the first data that expresses the N pieces of second data that are expressed by the first coefficient information, the M pieces of first data may be all or a part of the first data in the to-be-compressed data.

It should be noted that, in the at least one piece of first data that expresses the second data, each piece of first data has an expression capability for the second data, and expression capabilities of the at least one piece of first data for the second data may be different. Certainly, some of the first data may have a same expression capability for the second data, or all of the first data may have a same expression capability for the second data. This is not limited in this application. The expression capability of each piece of first data for the second data may be reflected by the expression coefficient. For example, a larger absolute value of the expression coefficient indicates a stronger expression capability.

In a first implementation, the first coefficient sub-information may include an expression coefficient of each piece of first data that expresses the second data. The expression coefficient indicates an expression capability of the corresponding first data for the second data.

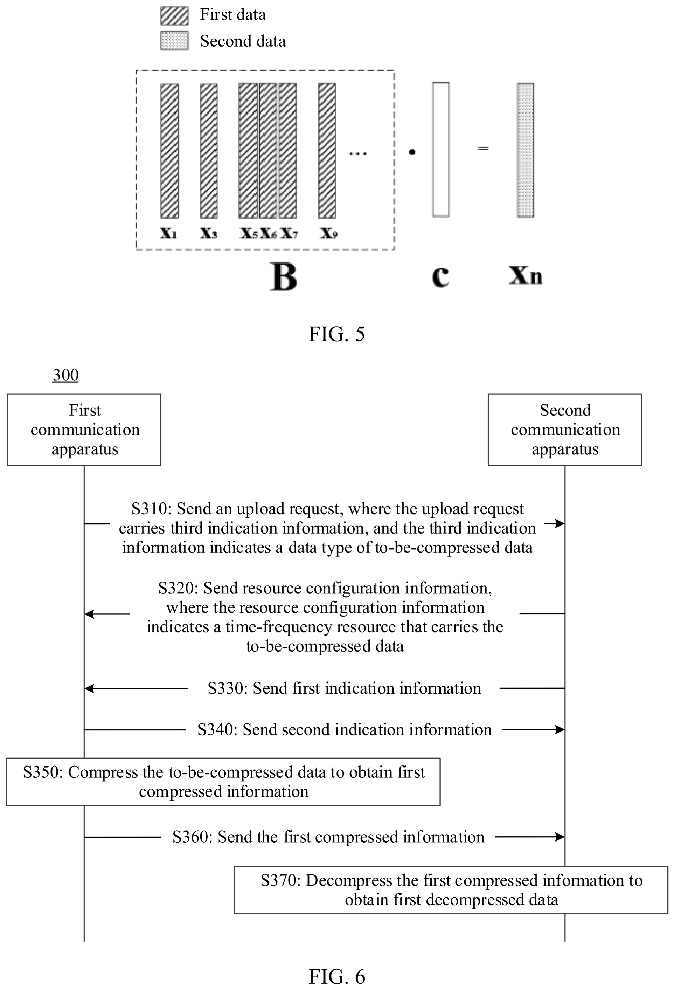

Refer to FIG. 5, an example in which the first base information (for example, a matrix B) includes column vectors $x_1$, $x_3$, $x_5$, $x_6$, $x_7$, $x_9$, ... in the matrix X shown in FIG. 4 is used. When the column vectors $x_1$, $x_3$, $x_5$, $x_6$, $x_7$, $x_9$, ... in the matrix B are used to express a column vector $x_n$ ($x_n$ is not the first data, for example, $x_n$ may be any one of $x_2$, $x_4$, $x_8$, ...) in the matrix X, $x_n$ may be expressed as $x_n = B \cdot c$. First coefficient sub-information whose vector c is $x_n$ may be, for example, [0.5, 0.1, 0.7, 0.2, 0.1, 0.6, ...], which indicates that in the matrix B, an expression coefficient used when $x_1$ expresses $x_n$ is 0.5, an expression coefficient used when $x_3$ expresses $x_n$ is 0.1, an expression coefficient used when $x_5$ expresses $x_n$ is 0.7, an expression coefficient used when $x_6$ expresses $x_n$ is 0.2, ...

Optionally, to further increase a compression ratio, the first communication apparatus may set an expression coefficient close to zero in the first coefficient sub-information to zero, or in other words, the first communication apparatus may perform capability differentiation on the first data that expresses the second data, and reserve an expression coefficient corresponding to first data with a high expression capability. For example, the first communication apparatus reserves an expression coefficient that is in the first coefficient sub-information and that is greater than a first capability threshold, and sets an expression coefficient that is less than or equal to the first capability threshold to zero.

In a second implementation, the first coefficient sub-information may include an expression coefficient of first data (for example, a part or all of the M pieces of first data) that has a first capability of expressing the second data (for example, an expression coefficient is greater than a first capability threshold), the expression coefficient corresponds to one piece of first data that has the first capability of expressing corresponding second data, and the expression coefficient indicates an expression capability of the corresponding first data for the second data. An example in which the first base information (for example, a matrix B) includes column vectors $x_1$, $x_3$, $x_5$, $x_6$, $x_7$, $x_9$, ... in the matrix X shown in FIG. 4 is still used. It is assumed that the first capability threshold is 0.1. In this case, after an expression coefficient greater than 0.1 is reserved, first coefficient sub-information of $x_n$ (for example, a vector c) is [0.5, 0, 0.7, 0.2, 0, 0.6, ...]. Compared with the first implementation, in this implementation, a system sub-information does not include an expression coefficient corresponding to first data that does not have the first capability of expressing the second data. Therefore, in this implementation, the first coefficient sub-information may further include second location indication information, so that the second location indication information indicates a location of the at least one piece of first data that has the first capability of expressing the second data in the M pieces of first data. The foregoing example continues to be used. It is assumed that the first capability threshold is 0.1 and the first coefficient sub-information (for example, the vector c) of $x_n$ is [0.5, 0.7, 0.2, 0.6, ...]. In this case, the second location indication information may include a bitmap [1, 0, 1, 1, 0, 1, ...], which indicates that $x_1$, $x_5$, $x_6$, $x_9$, ... in the matrix B has the first capability of expressing the second data, an expression coefficient used when $x_1$ expresses $x_n$ is 0.5, an expression coefficient used when $x_3$ expresses $x_n$ is 0.7, an expression coefficient used when $x_6$ expresses $x_n$ is 0.2, an expression coefficient used when $x_9$ expresses $x_n$ is 0.6, ...

It should be understood that, after the first communication apparatus uses the first data to express the second data, to-be-transmitted second data may be replaced with the system sub-information that transmits and expresses the second data. Compared with direct transmission of the second data, this transmission implements compression and transmission of the data.

It should be understood that, in the first example, the first compressed information does not include the first coefficient information, and the first coefficient information may be independently transmitted, or the first coefficient information may be agreed on in a protocol. This is not limited in this application.

The first communication apparatus may quantize one or more of the first base information, the first location indication information, and the first coefficient information in the first compressed information, to implement further data compression. Optionally, the first communication apparatus may perform entropy encoding on one or more of the first base information, the first location indication information, and the first coefficient information in the first compressed information, to implement quantization.

It may be understood that a process in which the second communication apparatus decompresses the first compressed information to obtain the first decompressed data may be understood as an inverse processing process of the foregoing compression processing. The first decompressed data obtained through decompression may also be referred to as restored data or constructed data. Generally, there is a difference between the first decompressed data obtained by performing decompression by the second communication apparatus and original data (for example, the to-be-compressed data) before the first communication apparatus performs compression. A smaller difference between the first decompressed data and the original data indicates better effect of data compression and data construction. The first decompressed data includes M pieces of first data obtained through restoration and N pieces of second data obtained through restoration. For example, the M pieces of first data in the first decompressed data may be obtained through decompression on the first base information and the first location indication information in the first compressed information, and the N pieces of second data in the first decompressed data may be obtained through decompression on the M pieces of first data obtained through restoration, the first coefficient information, and the second location indication information.

For example, when the second communication apparatus decompresses the first base information, the first coefficient information, and the first location indication information in the first compressed information to obtain the second data, for any piece of second data (for example, an $m^{th}$ piece of second data $x_m$), the second communication apparatus may perform implementation in the following two possible manners.

Manner 1: The second communication apparatus may obtain the second data $x_m$ by performing weighted summation on at least one piece of first data that expresses the second data $x_m$ and an expression coefficient corresponding to each piece of first data. For example, the original data (for example, the to-be-compressed data) is the matrix X, and the second data $x_m$ may be restored according to the following formula (1):

$$x_m = \sum_n c_n x_n \quad (1)$$

$x_n$ is an $n^{th}$ piece of first data in the M pieces of first data in the first base information, and $c_n$ is an expression coefficient used when the first data $x_n$ expresses the second data $x_m$.

Manner 2: The second communication apparatus may obtain the second data $x_m$ based on the coefficient vector c and the base matrix B that is formed by the M pieces of first data in the first base information, where the coefficient vector includes the expression coefficient of the at least one piece of first data in the M pieces of first data expressing the second data. The following formula (2) may be expressed:

$$x_m = B \cdot c \quad (2)$$

Optionally, if the first communication apparatus quantizes one or more of the first base information, the first location indication information, and the first coefficient information in the first compressed information, to implement further data compression, the second communication apparatus needs to perform corresponding conversion to restore data before quantization.

Based on the foregoing example, the first communication apparatus implements different compression for the first data and the second data in the to-be-compressed data. The first data may be directly transmitted without being compressed, or the first data may be transmitted after quantization. After the second data in the first compressed information is expressed by using the first data, the first coefficient information used to express the second data is transmitted, or the first coefficient information obtained through quantization is transmitted. Therefore, compared with the second data, the first data has a lower compression ratio, that is, a larger amount of information about the original data is reserved. Based on this, in this embodiment of this application, how to determine the first data from the to-be-compressed data is considered based on the following two dimensions: 1. Data of high importance in the to-be-compressed data is used as the first data, so that the data of high importance is transmitted in a manner of a low compression ratio and high reliability; and 2. Some data of low correlation in the to-be-compressed data is considered as the first data, so that expression coefficients of the first data for the second data may be sparser, thereby improving a compression ratio of the second data.

For example, the first communication apparatus determines the M pieces of first data based on a first parameter and/or a second parameter of each piece of data in the to-be-compressed data. In some embodiments, the M pieces of first data are a part of the first data in the to-be-compressed data. The first communication apparatus may determine K pieces of first data based on the first parameters and/or the second parameters of all the pieces of data in the to-be-compressed data, where K is a positive integer greater than M, and the K pieces of first data may be all or a part of the first data in the to-be-compressed data, to determine the M pieces of first data from the K pieces of first data. The first parameter indicates correlation between corresponding data and other data in the to-be-compressed data, and the second parameter indicates importance of the corresponding data. For brevity, the following uses an example in which the first communication apparatus determines the M pieces of first data for description, and a process of determining the K pieces of first data is similar. The second communication apparatus may determine the M pieces of first data based on indication information of the first communication apparatus.

Correlation between one piece of data in the to-be-compressed data and one or more pieces of data other than the one piece of data in the to-be-compressed data may be determined, for example, based on linear correlation between the one piece of data and the one or more pieces of other data; or based on a difference between singular values obtained by performing singular value decomposition on the one piece of data and the one or more pieces of other data; or based on a component of the one piece of data in a plane that is formed by the one or more pieces of other data.

Importance of data in the to-be-compressed data may be related to a data source. For example, in the AI-split scenario, importance of intermediate features output by different filters is different, or importance of intermediate features output by different neural network layers is different. For another example, in the point cloud scenario, importance of spatial points at different locations is different.

Optionally, the second parameter of the data in the to-be-compressed data may be agreed on in the protocol or configured by a network device. For example, importance of data output by each filter at each neural network layer is agreed on in the protocol.

When the first communication apparatus determines the first data based on the first parameter, that is, correlation between the data in the to-be-compressed data, the first communication apparatus may determine, one by one, whether the data in the to-be-compressed data is the first data. For example, for any piece of data (for example, an $i^{th}$ piece of data) in the to-be-compressed data, the first communication apparatus may determine, based on correlation between current m' pieces of first data and the $i^{th}$ piece of data, whether the $i^{th}$ piece of data is first data, where m' is a positive integer less than M, and i is a positive integer. A $1^{st}$ piece of first data in the current m' pieces of first data may be any piece of data in the to-be-compressed data, and first data other than the $1^{st}$ piece of first data in the current m' pieces of first data may be determined in a manner same as that of the $i^{th}$ piece of data.

Optionally, when determining whether the $i^{th}$ piece of data is first data, the first communication apparatus may determine whether the $i^{th}$ piece of data is linearly unrelated to the current m' pieces of first data. When the $i^{th}$ piece of data is linearly unrelated to the current m' pieces of first data, it is determined that the $i^{th}$ piece of data is first data; or when the $i^{th}$ piece of data is linearly correlated to the current m' pieces of first data, it is determined that the $i^{th}$ piece of data is the second data. A determining condition for the correlation between the data is not limited in this application. For example, when the correlation between the $i^{th}$ piece of data and the current m' pieces of first data is greater than a threshold, it is determined that the $i^{th}$ piece of data is the second data; or when the correlation between the $i^{th}$ piece of data and the current m' pieces of first data is less than or equal to the threshold, it is determined that the $i^{th}$ piece of data is first data. For determining of correlation between data in the following, refer to the correlation determining solution. For brevity, details are not described again.

Optionally, the first communication apparatus may determine, one by one based on an order of the data in the to-be-compressed data, whether the data is the first data. To be specific, the $i^{th}$ piece of data is an $i^{th}$ piece of data obtained after the data in the to-be-compressed data is sorted in order. For example, whether the data in the to-be-compressed data is the first data is determined one by one in an order of column vectors from left to right of a matrix (for example, the matrix X in FIG. 4), or whether the data in the to-be-compressed data is the first data is determined one by one in an order of column vectors from right to left of a matrix, or whether the data in the to-be-compressed data is the first data is determined one by one in an order of importance of the data.

The first communication apparatus may determine a preset amount of first data. For example, the first communication apparatus determines the data in the to-be-compressed data one by one, and ends a process of determining the first data until an amount of first data is equal to a preset value M. The preset value M may be agreed on in the protocol, or may be configured by the network device, or may be preset by the first communication apparatus. The foregoing example continues to be used. When the $i^{th}$ piece of data is first data, the first communication apparatus determines whether m'+1 is equal to the preset value M, and ends the process of determining the first data when m'+1 is equal to the preset value M.

Alternatively, the first communication apparatus may determine all first data that meets a requirement in the to-be-compressed data. For example, the first communication apparatus determines the data in the to-be-compressed data one by one, and ends the process of determining the first data until all the data is traversed. The foregoing example continues to be used. When the $i^{th}$ piece of data is first data, the first communication apparatus determines whether the $i^{th}$ piece of data is a last piece of data other than the current m' pieces of first data in the to-be-compressed data, that is, whether m'+1 is equal to the total quantity P of the data in the to-be-compressed data. When m'+1 is equal to P, the process of determining the first data ends.

The foregoing example continues to be used. After determining that the $i^{th}$ piece of data is first data, the first communication apparatus may determine, based on the current m'+1 pieces of first data, whether a $j^{th}$ piece of data in the to-be-compressed data is the first data, where j is a positive integer. After determining that the $i^{th}$ piece of data is not the first data (for example, the second data), the first communication apparatus may determine, based on the current m' pieces of first data, whether a $j^{th}$ piece of data in the to-be-compressed data is the first data.

Optionally, when determining, from the to-be-compressed data, first data whose correlation is less than the threshold, the first communication apparatus may further determine the M pieces of first data based on linear correlation between vectors in the matrix. For example, the to-be-compressed data is the matrix X shown in FIG. 4, and the M pieces of first data are M linear unrelated column vectors in the matrix X.

The first communication apparatus may determine the first coefficient sub-information of each piece of second data based on the M pieces of first data. Optionally, the first communication apparatus may determine the first coefficient sub-information of the second data in the process of determining the first data, or the first communication apparatus may determine the first coefficient sub-information of the second data after determining the M pieces of first data.

The $i^{th}$ piece of data is used as an example. After determining that the $i^{th}$ piece of data is the second data, the first communication apparatus may perform data compression on the $i^{th}$ piece of data based on the m' pieces of first data, to obtain first coefficient sub-information of the $i^{th}$ piece of data. In this case, each expression coefficient in the first coefficient sub-information of the $i^{th}$ piece of data may correspond to one piece of first data in the m' pieces of first data, and the expression coefficient indicates an expression capability of corresponding first data for the $i^{th}$ piece of data. Alternatively, each expression coefficient in the first coefficient sub-information of the $i^{th}$ piece of data corresponds to first data that is in the m' pieces of first data and that has a first capability of expressing the $i^{th}$ piece of data, and the second location indication information in the first coefficient sub-information indicates, in the m' pieces of first data, the first data that has the first capability of expressing the $i^{th}$ piece of data.

The $i^{th}$ piece of data is still used as an example. The first communication apparatus determines that the $i^{th}$ piece of data is the second data, and may perform data compression on the $i^{th}$ piece of data based on the M pieces of first data, to obtain first coefficient sub-information of the $i^{th}$ piece of data. In this case, each expression coefficient in the first coefficient sub-information of the $i^{th}$ piece of data may correspond to one piece of first data in the M pieces of first data, and the expression coefficient indicates an expression capability of corresponding first data for the $i^{th}$ piece of data. Alternatively, each expression coefficient in the first coefficient sub-information of the $i^{th}$ piece of data corresponds to first data that is in the M pieces of first data and that has a first capability of expressing the $i^{th}$ piece of data, and the second location indication information in the first coefficient sub-information indicates, in the M pieces of first data, the first data that has the first capability of expressing the $i^{th}$ piece of data.

When the first communication apparatus determines the first coefficient sub-information of the second data in the process of determining the first data, the first base information changes as the first data increases, and correspondingly, a range interval indicated by the second location indication information changes accordingly. For example, when at least one piece of first data in the current m' pieces of first data expresses the $i^{th}$ piece of data, the second location indication information indicates the at least one piece of first data in the m' pieces of first data. After one piece of first data is added, at least one piece of first data in the m'+1 pieces of first data expresses a $j^{th}$ piece of data, and the second location indication information indicates the at least one piece of first data in the m'+1 pieces of first data. When the second location indication information includes a bitmap, a length of the bitmap increases as the first data in the first base information increases.

When the first communication apparatus determines the first coefficient sub-information of each piece of second data after determining the M pieces of first data, a quantity of pieces of first data in the first base information is fixed, and correspondingly, a range interval indicated by the second location indication information remains unchanged. In other words, at least one piece of first data that expresses the second data is indicated in the M pieces of first data, that is, a length of a bitmap in the second location indication information is fixed.

In some embodiments, in the process in which the first communication apparatus determines the M pieces of first data based on the first parameter of the data, the first communication apparatus may perform comprehensive determining based on the second parameter of the data. For example, the first communication apparatus may sort the data in descending order of second parameters of data in the to-be-compressed data, and determine the first data one by one for the sorted to-be-compressed data. For example, the first communication apparatus determines the $i^{th}$ piece of data from the to-be-compressed data in descending order of the second parameters, and determines, based on the current m' pieces of first data, whether the $i^{th}$ piece of data is first data. It should be understood that second parameters of the current m' pieces of first data are all greater than that of the $i^{th}$ piece of data, and i is an integer greater than m'.

In some embodiments, the first communication apparatus may determine, in the to-be-compressed data in descending order of the second parameters, first M pieces of data having lowest first parameters, and use the M pieces of data as the M pieces of first data. For example, the first communication apparatus may select the first M pieces of data from the to-be-compressed data in descending order of the second parameters, and determine whether there is data that is linearly correlated (or whose correlation is greater than a threshold) in the first M pieces of data. If there is the data that is linearly correlated (or whose correlation is greater than the threshold), the first communication apparatus replaces k pieces of data that are linearly correlated (or whose correlation is greater than the threshold) in the M pieces of data with first k pieces of data in descending order of second parameters other than the M pieces of data in the to-be-compressed data, determines whether M pieces of data obtained through replacement of the k pieces of data include data that is linearly correlated (or whose correlation is greater than the threshold), repeats this process until M pieces of data are linearly unrelated (or whose correlation is less than or equal to the threshold), and determines the M pieces of data as the M pieces of first data.

As described above, the first communication apparatus may quantize one or more of the first base information, the first location indication information, and the first coefficient information in the first compressed information, to implement further data compression. Generally, when the first communication apparatus quantizes the first base information (for example, the M pieces of first data) in the first compressed information and the first coefficient information of each piece of second data, quantities of used quantization bits are the same. However, because importance of different data in the to-be-compressed data may be different, using the same quantities of quantization bits for quantization causes a large compression loss of data with high importance, and reduces data compression reliability. Therefore, in some embodiments of this application, the first communication apparatus may determine a corresponding quantity of quantization bits based on the second parameter of each piece of data in the to-be-compressed data, so that more original data information is reserved for the data of high importance.

For example, the first communication apparatus may determine, based on the second parameter of each piece of data in the to-be-compressed data, an importance level corresponding to the data, and a quantity of quantization bits (or a quantization bit range) corresponding to each importance level, so that the first communication apparatus may determine the corresponding quantity of quantization bits (or the quantization bit range) based on the importance level of the data. When the data is first data, the first communication apparatus quantizes the first data in the first base information based on a quantity of quantization bits (or a quantization bit range) corresponding to the first data. When the data is the second data, the first communication apparatus may quantize the first coefficient sub-information of the second data based on a quantity of quantization bits (or a quantization bit range) corresponding to the second data.

Optionally, the importance level of each piece of data may be synchronized between the first communication apparatus and the second communication apparatus. For example, the first communication apparatus sends the first compressed information including the importance level of each piece of data to the second communication apparatus. For another example, the first communication apparatus may receive the importance level of each piece of data sent by the second communication apparatus, and perform quantization based on the importance level.

For example, the first communication apparatus may determine, based on a rate-distortion function, a second parameter of each piece of first data in the M pieces of first data, and a total quantity of quantization bits of the M pieces of first data, a quantity of quantization bits corresponding to each piece of first data in the M pieces of first data, and then quantize the first base information based on the quantity of quantization bits corresponding to each piece of first data. For example, the first communication apparatus may determine, based on a rate-distortion function, a second parameter of each piece of second data in the N pieces of second data, and a total quantity of quantization bits of the N pieces of second data, the quantity of quantization bits corresponding to each piece of second data in the N pieces of second data, and then quantize the first coefficient sub-information of the second data based on the quantity of quantization bits corresponding to each piece of second data.

The foregoing example continues to be used. In some scenarios, a mathematical expression may not be obtained for the rate-distortion function. In this case, the rate-distortion function may be replaced by an equation that provides an upper bound. Optionally, for the first data, the equation includes a value range parameter (that is, a difference between a maximum value and a minimum value) of each piece of first data in the first base information. For the second data, the equation includes a value range parameter of the first coefficient sub-information. Optionally, a value range corresponding to each piece of data may be synchronized between the first communication apparatus and the second communication apparatus. For example, the first compressed information sent by the first communication apparatus to the second communication apparatus may carry a value range corresponding to each piece of first data in the first base information and a value range corresponding to each piece of first coefficient sub-information.

Therefore, in this embodiment of this application, in a data compression and transmission process, the second data is expressed by using the first data in the to-be-compressed data, and further the transmitted first compressed information includes the expression coefficient of the first data for the second data. Compared with transmission of the second data, this transmission implements reliable and efficient compression of the data. Especially when a data amount of the to-be-compressed data is large, a compression ratio and compression reliability can be effectively improved, thereby reducing communication overheads.

In some scenarios, the first compressed information occupies a large quantity of bits. As a result, an expected compression ratio is not reached, or the first compressed information cannot be carried on a preconfigured transmission resource. For example, after compressing the to-be-compressed data, the first communication apparatus may obtain initial first compressed information, and determine whether the initial first compressed information is greater than or equal to a bit threshold. If the initial first compressed information is greater than or equal to the bit threshold, first compressed information whose occupied bits are less than the bit threshold is obtained through further compression.

The bit threshold may be determined based on a compression requirement, and bit thresholds corresponding to different data compression ratio requirements may be different. For example, the compression ratio requirement may be determined based on a transmission resource that carries the first compressed information. A first capability threshold and a second capability threshold in the following are similar to the foregoing case. Details are not described again.

This embodiment of this application provides the following several possible implementations for further compression, to implement bit selection and reduction.

Implementation 1:

It is assumed that the first communication apparatus compresses the to-be-compressed data based on the M pieces of first data in the K pieces of first data, to obtain the initial first compressed information. When the bit occupied by the first compressed information is greater than the bit threshold, the first communication apparatus may determine the M pieces of first data from the K pieces of first data based on a first parameter and/or a second parameter of each piece of first data in the K pieces of first data in the to-be-compressed data, where K is a positive integer greater than or equal to M. For the first parameter and the second parameter, refer to the description in the foregoing example. For brevity, details are not described again.

Implementation 2:

It is assumed that, in the initial first compressed information, the expression coefficient that expresses the second data corresponds to one piece of first data that is in the at least one piece of first data and that has a first capability of expressing corresponding second data. When the bit of the initial first compressed information is greater than the bit threshold, the first communication apparatus may perform selection on the expression coefficient based on importance of each piece of first data in the at least one piece of first data and/or the expression capability for the second data.

In the foregoing implementation 2, when performing selection on the expression coefficient based on the importance of each piece of first data, the first communication apparatus may determine, in the at least one piece of first data that expresses the second data, first data whose second parameter is less than an importance threshold. For example, an expression coefficient of the first data whose second parameter is less than the importance threshold for the second data is set to zero, to implement selection and reduction of the expression coefficient. In other words, a second parameter of first data corresponding to an expression coefficient obtained through selection is greater than or equal to the importance threshold.

In the foregoing implementation 2, when performing selection on the expression coefficient based on the expression capability of each piece of first data for the second data, the first communication apparatus may determine, in the at least one piece of first data, first data that has a second capability of expressing the second data. For example, an expression coefficient corresponding to first data that does not have the second capability of expressing the second data is set to zero, to implement selection and reduction of the expression coefficient. Therefore, first data corresponding to an expression coefficient obtained through selection has the second capability of expressing the second data, where the second capability is greater than the first capability. Optionally, the first communication apparatus may determine, when an absolute value of the expression coefficient of the first data for the second data is greater than the second capability threshold, that the first data has the second capability of expressing the second data; or when the expression coefficient of the first data for the second data is less than or equal to the second capability threshold, that the first data does not have the second capability of expressing the second data. Refer to FIG. 5. An example in which the first base information (for example, a matrix B) includes column vectors $x_1$, $x_3$, $x_5$, $x_6$, $x_7$, $x_9$, ... in the matrix X shown in FIG. 4 is used. When the column vectors $x_1$, $x_3$, $x_5$, $x_6$, $x_7$, $x_9$, ... in the matrix B are used to express a column vector $x_n$ ($x_n$ is not the first data, or $x_n$ does not belong to the matrix B) in the matrix X, $x_n$ may be expressed as $x_n = B \cdot c$. For example, the first coefficient sub-information whose vector c is $x_n$ may be [0.5, 0.1, 0.7, 0.2, 0.1, 0.6, ...]. It is assumed that the first capability threshold is 0.1. In this case, after an expression coefficient greater than 0.1 is reserved, the first coefficient sub-information of $x_n$ (for example, the vector c) is [0.5, 0, 0.7, 0.2, 0, 0.6, ...]. It is assumed that the second capability threshold is 0.2. In this case, after an expression coefficient greater than 0.2 is reserved, the first coefficient sub-information of $x_n$ (for example, the vector c) is [0.5, 0, 0.7, 0, 0, 0.6, ...].

In some embodiments, to improve data compression and transmission reliability, when transmission resources are limited, compression and transmission may be performed between the first communication apparatus and the second communication apparatus in an incremental transmission manner. For example, the first communication apparatus may send the first compressed information to the second communication apparatus in an initial transmission phase, and send second compressed information to the second communication apparatus in an incremental transmission phase. After receiving the first compressed information sent by the first communication apparatus in the initial transmission phase, the second communication apparatus may decompress the first compressed information to obtain the first decompressed data, and after receiving the second compressed information sent by the first communication apparatus in the incremental transmission phase, decompress the second compressed information to obtain the second decompressed data, to update a part or all of data in the first decompressed data. Alternatively, after receiving the first compressed information sent by the first communication apparatus in the initial transmission phase, the second communication apparatus waits for the second compressed information, and after receiving the second compressed information, decompresses the first compressed information and the second compressed information, to obtain final decompressed data, where the decompressed data includes updated data in the second compressed data and data that is not updated in the first compressed data.

The following uses six examples to describe different incremental transmission manners.

Example 1: In the incremental transmission process, the N pieces of second data are still expressed based on the M pieces of first data. A difference lies in that at least one piece of first data that expresses the second data in the incremental transmission phase is different from the at least one piece of first data that expresses the same second data in the initial transmission phase. The at least one piece of first data that expresses the second data in the incremental transmission phase being different from the at least one piece of first data that expresses the same second data in the initial transmission phase may be completely different or partially different. For example, in the initial phase, first five pieces of first data in the M pieces of first data are used to express the second data, and in the incremental transmission phase, last M-5 pieces of first data in the M pieces of first data are used to express the second data. Alternatively, in the initial phase, at least one piece of first data that is in the M pieces of first data and that has a first expression capability for the second data expresses the second data, and in the incremental transmission phase, at least one piece of first data that is in the M pieces of second data and that has a third expression capability for the second data expresses the second data, where the third expression capability is lower than the first expression capability.

In the foregoing example 1, the second compressed information may include second coefficient information, where the second coefficient information includes second coefficient sub-information respectively corresponding to the N pieces of second data, the second coefficient sub-information of the second data includes an expression coefficient of at least one piece of first data in the M pieces of first data for the second data, and an expression capability of the expression coefficient in the second coefficient sub-information for the second data is different from an expression capability of the expression coefficient in the corresponding first coefficient sub-information for the second data.

In the foregoing example 1, the second decompressed data includes N pieces of second data obtained through re-restoration.

Example 2: In the incremental transmission process, N' pieces of second data are expressed based on the M pieces of first data, where N' is a positive integer. The N' pieces of second data may be all or a part of second data in the to-be-compressed data other than the N pieces of second data. For N' pieces of second data in another example, refer to the descriptions of the N' pieces of second data in this example. For brevity, details are not described again. In this case, the second compressed information may include: second coefficient information and third location indication information, where the second coefficient information includes second coefficient sub-information respectively corresponding to the N' pieces of second data, the second coefficient sub-information of the second data includes an expression coefficient of at least one piece of first data in the M pieces of first data for the second data, and the third location indication information indicates locations of the N' pieces of second data in the to-be-compressed data; and the second decompressed data includes the N' pieces of second data obtained through restoration.

Example 3: In the incremental transmission process, the N pieces of second data are expressed based on M' pieces of first data, where M' is a positive integer. The M' pieces of first data may be all or a part of first data in the to-be-compressed data other than the M pieces of first data. For example, the M pieces of first data and the M' pieces of first data may be included in the K pieces of first data. A manner in which the first communication apparatus determines the M' pieces of first data may be the same as the foregoing manner of determining the M pieces of first data, or the first communication apparatus may determine the K pieces of first data, and determine the M pieces of first data and the M' pieces of first data from the K pieces of first data.

In the foregoing example 3, the second compressed information may include: second base information and third location indication information, or second base information, second coefficient information, and third location indication information, where the second base information includes the M' pieces of first data, the second coefficient information includes second coefficient sub-information respectively corresponding to the N pieces of second data, the second coefficient sub-information of the second data includes an expression coefficient of at least one piece of first data in the M' pieces of first data for the second data, and the third location indication information indicates locations of the M' pieces of first data in the to-be-compressed data; and the second decompressed data includes: M' pieces of first data obtained through restoration and N pieces of second data obtained through re-restoration.

An example in which the M pieces of first data and the M' pieces of first data (for example, the matrix B) include column vectors $x_1, x_3, x_5, x_6, x_7, x_9, \ldots$ in the matrix X shown in FIG. 4 is used. It is assumed that first coefficient sub-information (for example, a vector c) of $x_n$ is [0.5, 0.1, 0.7, 0.2, 0.1, 0.6, ...]. The first base information may include column vectors $x_1, x_3, x_5, \ldots$ in the matrix X, and the second base information may include column vectors $x_6, x_7, x_9, \ldots$ in the matrix X. First coefficient sub-information (for example, a vector c) that expresses $x_n$ in the first coefficient information may be [0.5, 0.1, 0.7, ...], and first coefficient sub-information (for example, a vector c) that expresses $x_n$ in the second coefficient information may be [0.2, 0.1, 0.6, ...]. The first location indication may be [1, 0, 1, 0, 1, 0, 0, 0, 0, ...], and the third location indication information may be [0, 0, 0, 0, 0, 1, 1, 0, 1, ...].

Example 4: In the incremental transmission process, N' pieces of second data are expressed based on M' pieces of first data. In this case, the second compressed information includes: second base information and third location indication information, or second base information, second coefficient information, and third location indication information, where the second base information includes the M' pieces of first data, the second coefficient information includes second coefficient sub-information respectively corresponding to the N' pieces of second data, the second coefficient sub-information of the second data includes an expression coefficient of at least one piece of first data in the M' pieces of first data for the second data, and the third location indication information indicates locations of the M' pieces of first data and/or locations of the N' pieces of second data in the to-be-compressed data; and the second decompressed data includes: M' pieces of first data obtained through restoration, and N' pieces of second data obtained through restoration.

Example 5: In the incremental transmission process, the N pieces of second data and N' pieces of second data are expressed based on M' pieces of first data. In this case, the second compressed information includes: second base information and third location indication information, or second base information, second coefficient information, and third location indication information, where the second base information includes the M' pieces of first data, the second coefficient information includes second coefficient sub-information corresponding to each second data in the N pieces of second data and/or second coefficient sub-information corresponding to each second data in the N' pieces of second data, the second coefficient sub-information of the second data includes an expression coefficient of at least one piece of first data in the M' pieces of first data for the second data, and the third location indication information indicates locations of the M' pieces of first data and/or locations of the N' pieces of second data in the to-be-compressed data; and the second decompressed data includes: M' pieces of first data obtained through restoration, N pieces of second data obtained through re-restoration, and N' pieces of second data obtained through restoration.

Example 6: In the incremental transmission process, the N pieces of second data are expressed based on M+M' pieces of first data. In this case, the second compressed information includes: second base information and third location indication information, or second base information, second coefficient information, and third location indication information, where the second base information includes M' pieces of first data, the second coefficient information includes second coefficient sub-information respectively corresponding to the N pieces of second data, the second coefficient sub-information of the second data includes an expression coefficient of at least one piece of first data in the M pieces of first data and the M' pieces of first data for the second data, and the third location indication information indicates locations of the M' pieces of first data and/or locations of the N pieces of second data in the to-be-compressed data; and the second decompressed data includes: M' pieces of first data obtained through restoration and N pieces of second data obtained through re-restoration.

Example 7: In the incremental transmission process, N' pieces of second data are expressed based on M+M' pieces of first data. In this case, the second compressed information includes: second base information and third location indication information, or second base information, second coefficient information, and third location indication information, where the second base information includes the M' pieces of first data, the second coefficient information includes second coefficient sub-information respectively corresponding to the N' pieces of second data, the second coefficient sub-information of the second data includes an expression coefficient of at least one piece of first data in the M pieces of first data and the M' pieces of first data for the second data, and the third location indication information indicates locations of the M' pieces of first data and/or locations of the N' pieces of second data in the to-be-compressed data; and the second decompressed data includes: M' pieces of first data obtained through restoration, and N' pieces of second data obtained through restoration.

Example 8: In the incremental transmission process, the N pieces of second data and N' pieces of second data are expressed based on M+M' pieces of first data. In this case, the second compressed information includes: second base information and third location indication information, or second base information, second coefficient information, and third location indication information, where the second base information includes the M' pieces of first data, the second coefficient information includes second coefficient sub-information corresponding to each second data in the N pieces of second data and/or second coefficient sub-information corresponding to each second data in the N' pieces of second data, the second coefficient sub-information of the second data includes an expression coefficient of at least one piece of first data in the M pieces of first data and the M' pieces of first data for the second data, and the third location indication information indicates locations of the M' pieces of first data and/or locations of the N' pieces of second data in the to-be-compressed data; and the second decompressed data includes: M' pieces of first data obtained through restoration, N pieces of second data obtained through re-restoration, and N' pieces of second data obtained through restoration.

It should be noted that an allocation manner of the first data in the first base information and the second base information is not limited in this application. For example, M pieces of first data that are in the K pieces of first data and that have a high expression capability for the second data (for example, greater than the first capability threshold) may belong to the first base information, and M' pieces of first data that are in the K pieces of first data and that have a low expression capability for the second data (for example, greater than the third capability threshold and less than the first capability threshold) may belong to the second base information. Alternatively, first data of higher importance may be allocated to the first base information, and first data of lower importance may be allocated to the second base information.

It should be noted that content in the first compressed information and content in the second compressed information is not limited in this application. For example, the first compressed information may include the first base information and the first location indication information in the first compressed information, and the second compressed information may include the first coefficient information in the first compressed information.

FIG. 6 is a schematic interaction flowchart of a data compression and transmission method according to an embodiment of this application. As shown in FIG. 6, a method 300 includes a part or all of the following processes of S310 to S370.

S310: A first communication apparatus sends an upload request to a second communication apparatus, where the upload request carries third indication information, and the third indication information indicates a data type of to-be-compressed data. Correspondingly, the second communication apparatus receives the upload request sent by the first communication apparatus.

S320: The second communication apparatus sends resource configuration information to the first communication apparatus, where the resource configuration information indicates a time-frequency resource that carries the to-be-compressed data (or first compressed information). Correspondingly, the first communication apparatus receives the resource configuration information sent by the second communication apparatus.

S330: The second communication apparatus sends first indication information to the first communication apparatus, and correspondingly, the first communication apparatus receives the first indication information sent by the second communication apparatus.

S340: The first communication apparatus sends second indication information to the second communication apparatus, and correspondingly, the second communication apparatus receives the second indication information sent by the first communication apparatus.

S350: The first communication apparatus compresses the to-be-compressed data to obtain the first compressed information.

S360: The first communication apparatus sends the first compressed information to the second communication apparatus on the time-frequency resource, and correspondingly, the second communication apparatus receives, on the time-frequency resource, the first compressed information sent by the first communication apparatus.

S370: The second communication apparatus decompresses the first compressed information to obtain first decompressed data.

In S310, the first communication apparatus sends the upload request to the second communication apparatus, to request to compress and transmit the data. The upload request may carry the third indication information, to indicate the data type and/or a data size.

Optionally, the data type includes point cloud data or AI model data.

Optionally, the upload request may be a status report (status report, SR) or a buffer status report (buffer status report, BSR). For example, the first communication apparatus may implicitly indicate the data type by sending the upload request through the SR, or the first communication apparatus may report a size of the first data by sending the upload request through the BSR.

In S320, the time-frequency resource configured by the second communication apparatus may be fixed, or may be determined based on a type of data and/or a size of data reported by the first communication apparatus. Optionally, if the transmitted data is large and needs to be transmitted in an incremental transmission manner, the second communication apparatus may first configure a time-frequency resource required in an initial transmission phase (for example, the time-frequency resource for transmitting the first compressed information), and then configure a time-frequency resource required in the incremental transmission phase (for example, a time-frequency resource for transmitting second compressed information). Alternatively, the resource configuration information determined by the second communication apparatus may include a time-frequency resource required in the initial transmission phase and a time-frequency resource required in the incremental transmission phase.

In some embodiments, the first communication apparatus may determine the time-frequency resource, for example, determine the time-frequency resource based on a data type and/or a data size of to-be-transmitted data. Optionally, the first communication apparatus may send resource indication information to the second communication apparatus, to indicate the second communication apparatus to receive data on the video resource.

In S330, the second communication apparatus sends the first indication information to the first communication apparatus, so that the first communication apparatus performs data compression and transmission based on the first indication information.

Optionally, the first indication information may include at least one of the following:

> a quantity M of pieces of first data;
> a bit threshold; and
> a quantity of quantization bits of the to-be-compressed data.

It should be understood that the first communication apparatus may determine a corresponding quantity of pieces of first data from the to-be-compressed data based on the quantity M of pieces of the first data indicated by the first indication information.

The first communication apparatus may perform data compression based on the bit threshold in the first indication information, so that the obtained first compressed information does not exceed the bit threshold, or the first communication apparatus may perform bit selection and reduction or transmit the first compressed information in the incremental transmission manner when the first compressed information exceeds the bit threshold. The bit selection and reduction and the incremental transmission are described in the foregoing example. For brevity, details are not described again.

The first communication apparatus may perform data compression based on the quantity of quantization bits indicated in the first indication information. For example, the quantity of quantization bits indicated by the first indication information may include at least one of the following:

> a total quantity of quantization bits corresponding to the to-be-compressed data (or the first compressed information);
> a total quantity of quantization bits corresponding to the M pieces of first data;
> a total quantity of quantization bits corresponding to the N pieces of second data; and
> a quantity of quantization bits corresponding to each piece of data in the to-be-compressed data.

It may be understood that content indicated by the first indication information may be determined by the first communication apparatus, or may be agreed on in a protocol. For example, the first communication apparatus may determine at least one of the quantity M of pieces of the first data, the bit threshold, and the quantity of quantization bits of the to-be-compressed data based on the time-frequency resource that carries the to-be-compressed data (or the first compressed information). Optionally, the first communication apparatus may send the first indication information to the second communication apparatus, so that the second communication apparatus decompresses the first compressed information based on the first indication information to obtain the first decompressed data.

Optionally, when incremental transmission is implemented, the first indication information may further include at least one of the following:

> a quantity M' of pieces of first data;
> a bit threshold for incremental transmission; and
> a quantity of quantization bits for incremental transmission.

In a case of incremental transmission, the quantity of quantization bits indicated by the first indication information may further include at least one of the following:

a total quantity of quantization bits corresponding to the M' first data; and
a total quantity of quantization bits corresponding to the N' pieces of second data.

Optionally, the foregoing related information indicating incremental transmission may also be independent of the first indication information. When the related information indicating incremental transmission is independent of the first indication information, the related information indicating incremental transmission may be transmitted after the second communication apparatus sends the first indication information and before the first communication apparatus sends the second compressed information, or certainly the related information indicating incremental transmission may be sent before the second communication apparatus sends the first indication information. This is limited in this application.

In S340, the first communication apparatus sends the second indication information to the second communication apparatus, so that the second communication apparatus decompresses the first compressed information to obtain the first decompressed data. The second indication information indicates a value range of the first data and/or a value range of the first coefficient sub-information, the value range of the first data is used to determine a quantity of quantization bits of the first data, and the value range of the first coefficient sub-information is used to determine a quantity of quantization bits of the first coefficient sub-information.

Optionally, the first communication apparatus may indicate a quantity of expression coefficients in the first coefficient information to the second communication apparatus, for example, include a quantity of expression coefficients of each piece of first coefficient sub-information in the first coefficient information.

It should be understood that if both the first communication apparatus and the second communication apparatus are a terminal device or a component in a terminal device, any one of the foregoing indication information may be configured by a network device for the first communication apparatus and/or the second communication apparatus.

Both S350 and S370 are described in the foregoing embodiments. Details are not described herein again.

It should be noted that, in S350, when compressing the to-be-compressed data, the first communication apparatus may determine the first data based on at least one of a size of the time-frequency resource, the quantity M of pieces of the first data, the bit threshold, and the quantity of quantization bits of the to-be-compressed data, and determine a compression solution used to perform data compression. For example, when the network device indicates the quantity of pieces of first data, after determining the M pieces of first data, the first communication apparatus may use the M pieces of first data as a base to express each piece of second data. For another example, when the network device indicates at least one piece of first data, the first communication apparatus may determine, one by one based on the at least one piece of first data, whether other data in the to-be-compressed data is the first data, and express the second data by using currently confirmed first data when determining that the data is the second data. For another example, when the data in the to-be-compressed data has an importance level, the first communication apparatus determines the first data based on a second parameter of the data in the to-be-compressed data, and performs data compression.

An execution sequence of S320 to S340 is not limited in this embodiment, and an execution sequence of S350 and S360 and some steps in S320 to S340 is not limited. For example, the first indication information and the second indication information may be transmitted together with the first compressed information, or may be transmitted after the first compressed information.

An interaction procedure for transmitting the second compressed information is similar to the foregoing procedure for transmitting the first compressed information. For brevity, details are not described again.

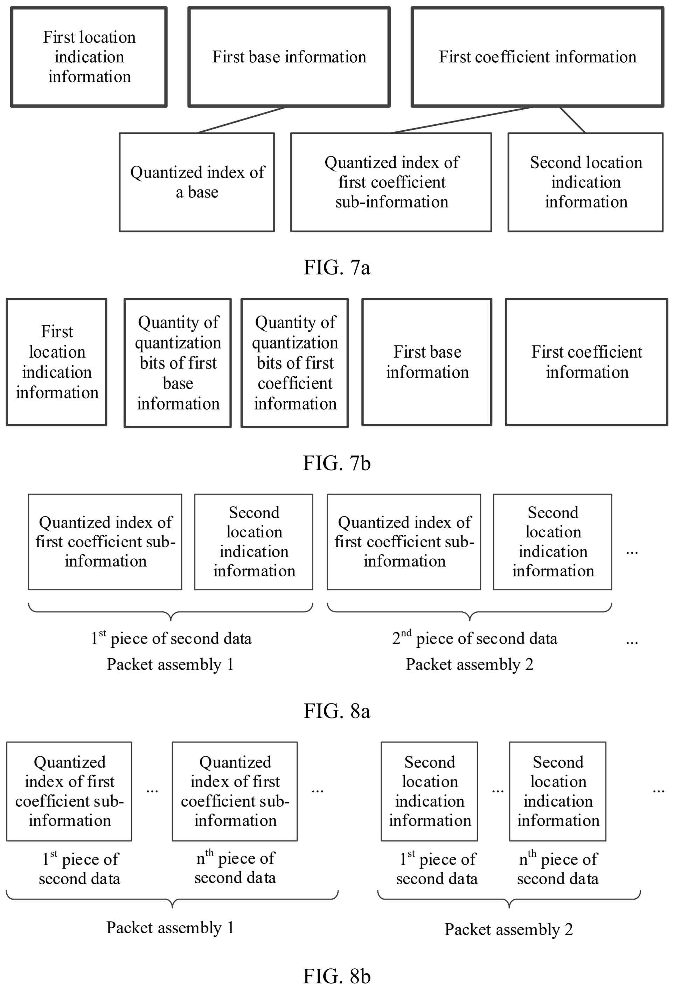

In some embodiments, if a bit occupied by the first compressed information is less than or equal to the bit threshold, for the first compressed information sent by the first communication apparatus, refer to FIG. 7a, that is, the first compressed information includes first location indication information, first base information, and first coefficient information. The first base information may include a quantized index (index) of a base (for example, the first data), and the first coefficient information may include a quantized index of first coefficient sub-information that expresses at least one piece of second data and second location indication information (for example, a bitmap). If the bit occupied by the first compressed information is greater than the bit threshold, for the first compressed information sent by the first communication apparatus, refer to FIG. 7b, that is, in addition to the first location indication information, the first base information, and the first coefficient information, the first compressed information further includes indication information of the quantization bit. The indication information of the quantization bit includes a quantity of quantization bits of the first base information and a quantity of quantization bits of the first coefficient information. It may be understood that, when the first indication information indicates the quantization bit, the first compressed information may not include the indication information of the quantization bit. The second compressed information is similar to the first compressed information. For brevity, details are not described again.

In some embodiments, for a quantized index of first coefficient sub-information corresponding to each piece of second data in the first coefficient information and second location indication information (for example, a bitmap) corresponding to each piece of second data, the first communication apparatus may perform sending in two packet assembly manners shown in FIG. 8a and FIG. 8b.

Refer to FIG. 8a. The first communication apparatus may perform packet assembly on the quantized index of the first coefficient sub-information of each piece of second data and the second location indication information. Refer to FIG. 8b, the first communication apparatus may perform packet assembly on quantized indexes of first coefficient sub-information of all pieces of second data expressed by using the first coefficient information, and perform packet assembly on second location indication information of all the pieces of second data.

A packet assembly manner of the second compressed information is similar to the packet assembly manner of the first compressed information. For brevity, details are not described again.

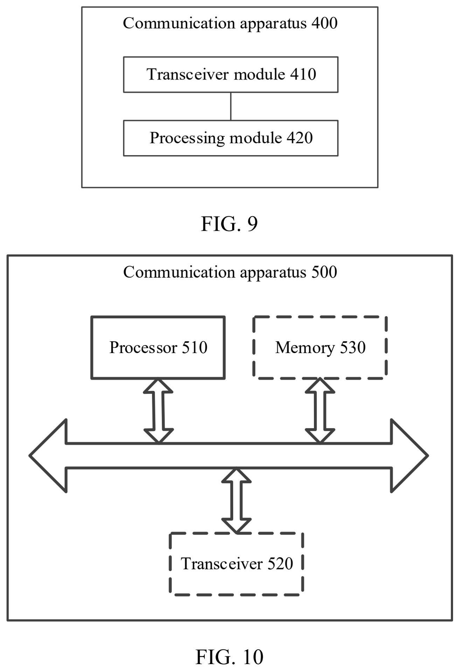

FIG. 9 is a block diagram of a communication apparatus according to an embodiment of this application. A communication apparatus 400 may be a terminal or a network device, may be an apparatus in a terminal device or a network device, or may be an apparatus that can be used together with a terminal device or a network device. In a possible implementation, the communication apparatus 400 may include modules or units that one-to-one correspond to the methods/operations/steps/actions performed by the first communication apparatus or the second communication apparatus in the foregoing method embodiments, and the units may be implemented by a hardware circuit, software, or a combination of a hardware circuit and software. In a possible implementation, as shown in FIG. 9, the apparatus 400 may include a transceiver module 410 and a processing module 420.

Optionally, the communication apparatus 400 may correspond to the first communication apparatus in the foregoing method embodiments.

When the communication apparatus 400 is configured to perform the method on a first communication apparatus side, the processing module 420 may be configured to compress to-be-compressed data to obtain first compressed information, where the first compressed information includes: first base information and first location indication information, or first base information, first coefficient information, and first location indication information, where the first base information includes M pieces of first data in the to-be-compressed data, M is a positive integer, the first coefficient information includes first coefficient sub-information respectively corresponding to N pieces of second data in the to-be-compressed data, N is a positive integer, the first coefficient sub-information of the second data includes an expression coefficient of at least one piece of first data in the M pieces of first data for the second data, and the first location indication information indicates locations of the M pieces of first data and/or locations of the N pieces of second data in the to-be-compressed data; and the transceiver module 410 may be configured to send the first compressed information.

It should be understood that specific processes performed by the modules are described in detail in the foregoing method embodiments. For brevity, details are not described herein again.

Optionally, the communication apparatus 400 may correspond to the second communication apparatus in the foregoing method embodiments.

When the communication apparatus 400 is configured to perform the method on a second communication apparatus side, the transceiver module 410 may be configured to receive first compressed information, where the first compressed information includes: first base information and first location indication information, or first base information, first coefficient information, and first location indication information, where the first base information includes M pieces of first data in the to-be-compressed data, M is a positive integer, the first coefficient information includes first coefficient sub-information respectively corresponding to N pieces of second data in the to-be-compressed data, N is a positive integer, the first coefficient sub-information of the second data includes an expression coefficient of at least one piece of first data in the M pieces of first data for the second data, and the first location indication information indicates locations of the M pieces of first data and/or locations of the N pieces of second data in the to-be-compressed data; and the processing module 420 may be configured to perform decompression based on the first compressed information to obtain first decompressed data, where the first decompressed data includes M pieces of first data obtained through restoration and N pieces of second data obtained through restoration.

It should be understood that specific processes performed by the modules are described in detail in the foregoing method embodiments. For brevity, details are not described herein again.

The transceiver module 410 in the communication apparatus 400 may be implemented via a transceiver, for example, may correspond to a transceiver 520 in a communication apparatus 500 shown in FIG. 10. The processing module 420 in the communication apparatus 400 may be implemented via at least one processor, for example, may correspond to a processor 510 in the communication apparatus 500 shown in FIG. 10.

When the communication apparatus 400 is a chip or a chip system configured in a communication device (for example, a terminal device or a network device), the transceiver module 410 in the communication apparatus 400 may be implemented by using an input/output interface, a circuit, or the like, and the processing module 420 in the communication apparatus 400 may be implemented by using a processor, a microprocessor, an integrated circuit, or the like integrated on the chip or the chip system.

FIG. 10 is another block diagram of a communication apparatus according to an embodiment of this application. As shown in FIG. 10, the communication apparatus 500 may include a processor 510. The processor 510 may be configured to perform the method performed by the first communication apparatus or the second communication apparatus in the foregoing method embodiments.

In some possible implementations, the communication apparatus 500 may include the transceiver 520. The transceiver 520 and the processor 510 may communicate with each other through an internal connection path. The processor 510 may control the transceiver 520 to send a signal and/or receive a signal.

In some possible implementations, the communication apparatus 500 may include a memory 530. The memory 530 and the processor 510 may communicate with each other through an internal connection path. The memory 530 and the processor 510 may be integrated together, or may be disposed separately. The memory 530 may alternatively be a memory outside the apparatus. The memory 530 is configured to store instructions, and the processor 510 is configured to execute the instructions stored in the memory 530, to perform the methods in the foregoing method embodiments.

It should be understood that the communication apparatus 500 may correspond to the terminal device or the network device in the foregoing method embodiments, and may be configured to perform steps and/or procedures performed by the first communication apparatus or the second communication apparatus in the foregoing method embodiments. Optionally, the memory 530 may include a read-only memory and a random access memory, and provide instructions and data for the processor. A part of the memory may further include a non-volatile random access memory. The memory 530 may be a separate component, or may be integrated in the processor 510. The processor 510 may be configured to execute the instructions stored in the memory 530. When the processor 510 executes the instructions stored in the memory, the processor 510 is configured to perform the steps and/or procedures corresponding to the terminal device or the network device in the foregoing method embodiments.

Optionally, the communication apparatus 500 is the first communication apparatus in the foregoing embodiments.

Optionally, the communication apparatus 500 is the second communication apparatus in the foregoing embodiments.

The transceiver 520 may include a transmitter and a receiver. The transceiver 520 may further include one or more antennas. The processor 510, the memory 530, and the transceiver 520 may be devices integrated in different chips. For example, the processor 510 and the memory 530 may be integrated in a baseband chip, while the transceiver 520 may be integrated in a radio frequency chip. The processor 510, the memory 530, and the transceiver 520 may alternatively be devices integrated in a same chip. This is not limited in this application.

Optionally, the communication apparatus 500 is a component configured in the terminal device, for example, a chip or a chip system.

Optionally, the communication apparatus 500 is a component configured in the network device, for example, a chip or a chip system.

The transceiver 520 may alternatively be a communication interface, for example, an input/output interface or a circuit. The transceiver 520, the processor 510, and the memory 530 may be integrated in a same chip, for example, integrated in a baseband chip.

This application further provides a processing apparatus, including at least one processor. The at least one processor enables, by running a computer program or using a logic circuit, the processing apparatus to perform the method performed by the first communication apparatus or the second communication apparatus in the foregoing method embodiments. The processing apparatus may further include a memory. The memory is configured to store the computer program.

An embodiment of this application further provides a processing apparatus. The processing apparatus includes a processor and an input/output interface. The input/output interface is coupled to the processor. The input/output interface is configured to input and/or output information. The information includes at least one of instructions and data. The processor is configured to execute a computer program to enable the processing apparatus to perform the method performed by the first communication apparatus or the second communication apparatus in the foregoing method embodiments.

An embodiment of this application further provides a processing apparatus. The processing apparatus includes a processor and a memory. The memory is configured to store a computer program. The processor is configured to invoke the computer program from the memory and run the computer program, so that the processing apparatus performs the method performed by the first communication apparatus or the second communication apparatus in the foregoing method embodiments.

It should be understood that the processing apparatus may be one or more chips. For example, the processing apparatus may be a field programmable gate array (field programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable controller (programmable logic device, PLD), or another integrated chip.

In an implementation process, steps in the foregoing methods can be implemented by using a hardware integrated logic circuit in the processor, or by using instructions in a form of software. The steps of the method disclosed with reference to embodiments of this application may be directly performed by a hardware processor, or may be performed by using a combination of hardware in the processor and a software module. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor. To avoid repetition, details are not described herein again.

It should be noted that, the processor in embodiments of this application may be an integrated circuit chip, and has a signal processing capability. In an implementation process, steps in the foregoing method embodiments can be implemented by using a hardware integrated logic circuit in the processor, or by using instructions in a form of software. The processor may be a general purpose processor, a digital signal processor (DSP), an application specific integrated circuit (ASIC), a field programmable gate array (FPGA) or another programmable logic device, a discrete gate or a transistor logic device, or a discrete hardware component. It may implement or perform the methods, the steps, and logical block diagrams that are disclosed in embodiments of this application. The general-purpose processor may be a microprocessor, or the processor may be any conventional processor or the like. The steps of the method disclosed with reference to embodiments of this application may be directly performed by a hardware decoding processor, or may be performed by using a combination of hardware in the decoding processor and a software module. A software module may be located in a mature storage medium in the art, such as a random access memory, a flash memory, a read-only memory, a programmable read-only memory, an electrically erasable programmable memory, or a register. The storage medium is located in the memory, and a processor reads information in the memory and completes the steps in the foregoing methods in combination with hardware of the processor.

It may be understood that the memory in this embodiment of this application may be a volatile memory or a nonvolatile memory, or may include a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. Through example but not limitative description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus dynamic random access memory (direct rambus RAM, DR RAM). It should be noted that the memory of the systems and methods described in this specification includes but is not limited to these and any memory of another proper type.

According to the method provided in embodiments of this application, this application further provides a computer program product. The computer program product includes a computer program or a set of instructions. When the computer program or the set of instructions are run on a computer, the computer is enabled to perform the method performed by the first communication apparatus or the second communication apparatus in the foregoing method embodiments.

According to the method provided in embodiments of this application, this application further provides a computer-readable storage medium. The computer-readable storage medium stores a program. When the program is run on a computer, the computer is enabled to perform the method performed by the first communication apparatus or the second communication apparatus in the foregoing method embodiments.

According to the method provided in embodiments of this application, this application further provides a communication system. The communication system may include the foregoing first communication apparatus or second communication apparatus.

Terminologies such as "component", "module", and "system" used in this specification are used to indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As illustrated by using figures, both a computing device and an application that runs on the computing device may be components. One or more components may reside within a process and/or a thread of execution, and a component may be located on one computer and/or distributed between two or more computers. In addition, these components may be executed from various computer-readable media that store various data structures. For example, the components may communicate by using a local and/or remote process and based on, for example, a signal having one or more data packets (for example, data from two components interacting with another component in a local system, a distributed system, and/or across a network such as the Internet interacting with other systems by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, in other words, may be located in one location, or may be distributed on a plurality of network units. A part or all of the units may be selected based on actual requirements to achieve the objectives of the solutions of embodiments.

In addition, functional units in embodiments of this application may be integrated into one processing unit, or each of the units may exist alone physically, or two or more units may be integrated into one unit.

When functions are implemented in the form of a software functional unit and sold or used as an independent product, the functions may be stored in a computer-readable storage medium. Based on such an understanding, a part contributing to the technical solutions in this application, or a part of the technical solutions may be embodied in a form of a software product. The computer software product is stored in a storage medium, and includes several instructions for instructing a computer device (which may be a personal computer, a server, a network device, or the like) to perform all or some steps of the methods in embodiments of this application. The foregoing storage medium includes any medium that can store program code, such as a USB flash drive, a removable hard disk, a ROM, a RAM, a magnetic disk, or an optical disc.

**Claims**

1. A data compression and transmission method, comprising:

   compressing the to-be-compressed data to obtain first compressed information, wherein the first compressed information comprises: first base information and first location indication information, or first base information, first coefficient information, and first location indication information, wherein the first base information comprises M pieces of first data in the to-be-compressed data, M is a positive integer, the first coefficient information comprises first coefficient sub-information respectively corresponding to N pieces of second data in the to-be-compressed data, N is a positive integer, the first coefficient sub-information of the second data comprises an expression coefficient of at least one piece of first data in the M pieces of first data for the second data, and the first location indication information indicates locations of the M pieces of first data and/or locations of the N pieces of second data in the to-be-compressed data; and sending the first compressed information.

2. The method according to claim 1, wherein the first coefficient sub-information of the second data further comprises second location indication information, and the second location indication information indicates a location of at least one piece of first data expressing the second data in the M pieces of first data.

3. The method according to claim 1 or 2, wherein the expression coefficient corresponds to one piece of first data that has a first capability of expressing corresponding second data, and the expression coefficient indicates an expression capability of the corresponding first data for the second data.

4. The method according to any one of claims 1 to 3, further comprising:
   sending second compressed information, wherein the second compressed information comprises:

   second coefficient information, wherein the second coefficient information comprises second coefficient sub-information respectively corresponding to the N pieces of second data, the second coefficient sub-information of the second data comprises an expression coefficient of at least one piece of first data in the M pieces of first data for the second data, and an expression capability of the expression coefficient in the second coefficient sub-information for the second data is different from an expression capability of the expression coefficient in the corresponding first coefficient sub-information for the second data; or

second coefficient information and third location indication information, wherein the second coefficient information comprises second coefficient sub-information respectively corresponding to N' pieces of second data in the to-be-compressed data other than the N pieces of second data, N' is a positive integer, the second coefficient sub-information of the second data comprises an expression coefficient of at least one piece of first data in the M pieces of first data for the second data, and the third location indication information indicates locations of the N' pieces of second data in the to-be-compressed data; or

second base information and third location indication information, or second base information, second coefficient information, and third location indication information, wherein the second base information comprises M' pieces of first data in the to-be-compressed data other than the M pieces of first data, M' is a positive integer, the second coefficient information comprises second coefficient sub-information corresponding to the N pieces of second data and/or second coefficient sub-information corresponding to N' pieces of second data in the to-be-compressed data other than the N pieces of second data, the second coefficient sub-information of the second data comprises an expression coefficient of at least one piece of first data in the M' pieces of first data for the second data, and the third location indication information indicates locations of the M' pieces of first data and/or locations of the N' pieces of second data in the to-be-compressed data; or

second base information and third location indication information, or second base information, second coefficient information, and third location indication information, wherein the second base information comprises M' pieces of first data in the to-be-compressed data other than the M pieces of first data, the second coefficient information comprises second coefficient sub-information corresponding to the N pieces of second data and/or second coefficient sub-information corresponding to N' pieces of second data in the to-be-compressed data other than the N pieces of second data, the second coefficient sub-information of the second data comprises an expression coefficient of at least one piece of first data in the M pieces of first data and the M' pieces of first data for the second data, and the third location indication information indicates locations of the M' pieces of first data and/or locations of the N' pieces of second data in the to-be-compressed data.

5. The method according to any one of claims 1 to 4, further comprising:
determining the M pieces of first data based on a first parameter and/or a second parameter of each piece of data in the to-be-compressed data, wherein the first parameter indicates correlation between corresponding data and other data in the to-be-compressed data, and the second parameter indicates importance of the corresponding data.

6. The method according to any one of claims 1 to 5, further comprising:
determining, based on correlation between current $m'$ pieces of first data and an $i^{th}$ piece of data in the compressed data, whether the $i^{th}$ piece of data is first data, wherein $m'$ is a positive integer less than M, and i is a positive integer.

7. The method according to claim 6, further comprising:
when the $i^{th}$ piece of data in the to-be-compressed data is second data, performing data compression on the $i^{th}$ piece of data based on the current $m'$ pieces of first data.

8. The method according to any one of claims 1 to 7, further comprising: selecting the M pieces of first data in descending order of second parameters of data in the to-be-compressed data, wherein the second parameter indicates importance of corresponding data.

9. The method according to any one of claims 1 to 8, further comprising:
determining, in the to-be-compressed data in descending order of the second parameters, first M pieces of data having lowest first parameters, and using the M pieces of data as the M pieces of first data, wherein the second parameter indicates importance of corresponding data, and the first parameter indicates correlation between the corresponding data and other data in the to-be-compressed data.

10. The method according to any one of claims 1 to 9, wherein the first compressed information comprises an importance level, and the importance level indicates a quantity of quantization bits of corresponding data.

**11.** The method according to any one of claims 1 to 10, further comprising:
determining the M pieces of first data from K pieces of first data in the to-be-compressed data based on a first parameter and/or a second parameter of each piece of first data in the K pieces of first data, wherein K is a positive integer greater than M, the first parameter indicates correlation between corresponding first data and other data in the to-be-compressed data, and the second parameter indicates importance of the corresponding first data.

**12.** The method according to any one of claims 1 to 11, wherein the expression coefficient corresponds to one piece of first data that is in the at least one piece of first data and that has a first capability of expressing corresponding second data, and the expression coefficient indicates an expression capability of the corresponding first data for the second data; and
when a bit of the first compressed information is greater than a bit threshold, performing selection on the expression coefficient based on importance of each piece of first data in the at least one piece of first data and/or an expression capability for the second data, wherein a second parameter of first data corresponding to a selected expression coefficient is greater than or equal to an importance threshold, and/or the first data corresponding to the selected expression coefficient has a second capability of expressing the second data, the second capability is greater than the first capability, and the second parameter indicates importance of the corresponding first data.

**13.** The method according to any one of claims 1 to 12, further comprising:
sending or receiving first indication information, wherein the first indication information indicates an amount of first data.

**14.** The method according to any one of claims 1 to 13, further comprising:
sending second indication information, wherein the second indication information indicates a value range of the first data, and the value range of the first data is used to determine a quantity of quantization bits of the first data.

**15.** The method according to any one of claims 1 to 14, further comprising:
determining a total quantity of quantization bits of the to-be-compressed data based on a time-frequency resource.

**16.** A data compression and transmission method, comprising:

receiving first compressed information, wherein the first compressed information comprises: first base information and first location indication information, or first base information, first coefficient information, and first location indication information, wherein the first base information comprises M pieces of first data in the to-be-compressed data, M is a positive integer, the first coefficient information comprises first coefficient sub-information respectively corresponding to N pieces of second data in the to-be-compressed data, N is a positive integer, the first coefficient sub-information of the second data comprises an expression coefficient of at least one piece of first data in the M pieces of first data for the second data, and the first location indication information indicates locations of the M pieces of first data and/or locations of the N pieces of second data in the to-be-compressed data; and decompressing the first compressed information to obtain first decompressed data, wherein the first decompressed data comprises M pieces of first data obtained through restoration and N pieces of second data obtained through restoration.

**17.** The method according to claim 16, wherein the coefficient sub-information of the second data further comprises second location indication information, and the second location indication information indicates a location of at least one piece of first data expressing the second data in the M pieces of first data.

**18.** The method according to claim 16 or 17, wherein the expression coefficient corresponds to one piece of first data that has a first capability of expressing corresponding second data, and the expression coefficient indicates an expression capability of the corresponding first data for the second data.

**19.** The method according to any one of claims 16 to 18, further comprising:

receiving second compressed information; and decompressing the second compressed information to obtain second decompressed data, wherein
the second compressed information comprises: second coefficient information, wherein the second coefficient information comprises second coefficient sub-information respectively corresponding to the N pieces of second data, the second coefficient sub-information of the second data comprises an expression coefficient of at least one piece of first data in the M pieces of first data for the second data, and an expression capability of the expression coefficient in the second coefficient sub-information for the second data is different from an expression capability of the expression coefficient in the corresponding first coefficient sub-information for the second data; and the second decompressed data comprises N pieces of second data obtained through re-restoration; or

the second compressed information comprises: second coefficient information and third location indication information, wherein the second coefficient information comprises second coefficient sub-information respectively corresponding to N' pieces of second data in the to-be-compressed data other than the N pieces of second data, N' is a positive integer, the second coefficient sub-information of the second data comprises an expression coefficient of at least one piece of first data in the M pieces of first data for the second data, and the third location indication information indicates locations of the N' pieces of second data in the to-be-compressed data; and the second decompressed data comprises N' pieces of second data obtained through restoration; or

the second compressed information comprises: second base information and third location indication information, or second base information, second coefficient information, and third location indication information, wherein the second base information comprises M' pieces of first data in the to-be-compressed data other than the M pieces of first data, M' is a positive integer, the second coefficient information comprises second coefficient sub-information respectively corresponding to the N pieces of second data and/or second coefficient sub-information respectively corresponding to N' pieces of second data in the to-be-compressed data other than the N pieces of second data, the second coefficient sub-information of the second data comprises an expression coefficient of at least one piece of first data in the M' pieces of first data for the second data, and the third location indication information indicates locations of the M' pieces of first data and/or locations of the N' pieces of second data in the to-be-compressed data; and the second decompressed data comprises: M' pieces of first data obtained through restoration, and N pieces of second data obtained through re-restoration and/or N' pieces of second data obtained through restoration; or

the second compressed information comprises: second base information and third location indication information, or second base information, second coefficient information, and third location indication information, wherein the second base information comprises M' pieces of first data in the to-be-compressed data other than the M pieces of first data, the second coefficient information comprises second coefficient sub-information respectively corresponding to the N pieces of second data and/or second coefficient sub-information respectively corresponding to N' pieces of second data in the to-be-compressed data other than the N pieces of second data, the second coefficient sub-information of the second data comprises an expression coefficient of at least one piece of first data in the M pieces of first data and the M' pieces of first data for the second data, and the third location indication information indicates locations of the M' pieces of first data and/or locations of the N' pieces of second data in the to-be-compressed data; and the second decompressed data comprises: M' pieces of first data obtained through restoration and N' pieces of second data obtained through restoration.

20. The method according to any one of claims 16 to 19, wherein decompressing the first compressed information to obtain the first decompressed data comprises:

    restoring the M pieces of first data based on the first location indication information and base information; and
    restoring the N pieces of second data based on the M pieces of first data obtained through restoration, the first coefficient information, and the second location indication information, wherein the second location indication information indicates the location of the at least one piece of first data that expresses the second data in the M pieces of first data.

21. The method according to any one of claims 16 to 20, wherein the compressed information comprises an importance level, and the importance level indicates a quantity of quantization bits of corresponding data.

22. A communication apparatus, comprising a module configured to perform the method according to any one of claims 1 to 15 or comprising a module configured to perform the method according to any one of claims 16 to 21.

23. A communication apparatus, comprising a processor, wherein the processor is configured to perform the method according to any one of claims 1 to 21 by running a computer program or using a logic circuit.

24. The apparatus according to claim 23, further comprising a memory, wherein the memory is configured to store the computer program.

25. The apparatus according to claim 23 or 24, further comprising a communication interface, wherein the communication interface is configured to input and/or output a signal.

26. A communication system, comprising a first communication apparatus configured to perform the method according to any one of claims 1 to 15 and a second communication apparatus configured to perform the method according to any one of claims 16 to 21.

27. A computer-readable storage medium, configured to store computer program instructions, wherein the computer program enables a computer to perform the method according to any one of claims 1 to 21.

28. A computer program product, comprising computer program instructions, wherein the computer program instructions enable a computer to perform the method according to any one of claims 1 to 21.

FIG. 1

FIG. 2

EP 4 746 507 A1

200

| First communication apparatus | | Second communication apparatus |

S210: The first communication apparatus compresses to-be-compressed data to obtain first compressed information, where the first compressed information includes: first base information and first location indication information, and/or first base information, first coefficient information, and first location indication information, where the first base information includes M pieces of first data, M is a positive integer, the first coefficient information includes first coefficient sub-information respectively corresponding to N pieces of second data in the to-be-compressed data, the first coefficient sub-information of the second data includes an expression coefficient of at least one piece of first data in the M pieces of first data for the second data, and the first location indication information indicates a location of the first data and/or a location of the second data in the to-be-compressed data

S220: Send the first compressed information ⟶

S230: Decompress the first compressed information to obtain first decompressed data

FIG. 3

▨ First data

▨ Second data

$X_1\ X_2\ X_3\ X_4\ X_5\ X_6\ X_7\ X_8\ X_9$ $X_P$

Q

X

FIG. 4

First data
Second data

FIG. 5

300

| First communication apparatus | | Second communication apparatus |

S310: Send an upload request, where the upload request carries third indication information, and the third indication information indicates a data type of to-be-compressed data

S320: Send resource configuration information, where the resource configuration information indicates a time-frequency resource that carries the to-be-compressed data

S330: Send first indication information

S340: Send second indication information

S350: Compress the to-be-compressed data to obtain first compressed information

S360: Send the first compressed information

S370: Decompress the first compressed information to obtain first decompressed data

FIG. 6

| First location indication information | First base information | First coefficient information |
|---|---|---|

| Quantized index of a base | Quantized index of first coefficient sub-information | Second location indication information |
|---|---|---|

FIG. 7a

| First location indication information | Quantity of quantization bits of first base information | Quantity of quantization bits of first coefficient information | First base information | First coefficient information |
|---|---|---|---|---|

FIG. 7b

| Quantized index of first coefficient sub-information | Second location indication information | Quantized index of first coefficient sub-information | Second location indication information | ... |
|---|---|---|---|---|

1st piece of second data
Packet assembly 1

2nd piece of second data
Packet assembly 2

...

FIG. 8a

| Quantized index of first coefficient sub-information | ... | Quantized index of first coefficient sub-information | ... | Second location indication information | ... | Second location indication information | ... |
|---|---|---|---|---|---|---|---|

1st piece of second data

nth piece of second data

1st piece of second data

nth piece of second data

Packet assembly 1

Packet assembly 2

FIG. 8b

Communication apparatus 400

Transceiver module 410

Processing module 420

FIG. 9

Communication apparatus 500

Processor 510

Memory 530

Transceiver 520

FIG. 10

## INTERNATIONAL SEARCH REPORT

| International application No. |
| --- |
| **PCT/CN2023/114231** |

**A. CLASSIFICATION OF SUBJECT MATTER**

H04W 28/06(2009.01)i

According to International Patent Classification (IPC) or to both national classification and IPC

**B. FIELDS SEARCHED**

Minimum documentation searched (classification system followed by classification symbols)

IPC: H04W,H03M

Documentation searched other than minimum documentation to the extent that such documents are included in the fields searched

Electronic data base consulted during the international search (name of data base and, where practicable, search terms used)

CNTXT, WPABSC, ENTXTC, VEN, CJFD, CNKI: 数据压缩, 基信息, 表达系数, 位置, 指示, 相关性, 关联, data compression , basic information, expressing coefficient, position, indicat+, correlation

**C. DOCUMENTS CONSIDERED TO BE RELEVANT**

| Category* | Citation of document, with indication, where appropriate, of the relevant passages | Relevant to claim No. |
| --- | --- | --- |
| A | CN 105743509 A (HUAWEI TECHNOLOGIES CO., LTD.) 06 July 2016 (2016-07-06) entire document | 1-28 |
| A | CN 117318728 A (BAIDU TIMES NETWORK TECHNOLOGY (BEIJING) CO., LTD.) 29 December 2023 (2023-12-29) entire document | 1-28 |
| A | CN 115955248 A (SHENZHEN DAPU MICROELECTRONICS CO., LTD.) 11 April 2023 (2023-04-11) entire document | 1-28 |
| A | JP 2016134808 A (FUJITSU LTD.) 25 July 2016 (2016-07-25) entire document | 1-28 |

☐ Further documents are listed in the continuation of Box C.      ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
| --- | --- |
| **11 May 2024** | **12 May 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
|---|
| **PCT/CN2023/114231** |

| Patent document cited in search report | | | Publication date (day/month/year) | Patent family member(s) | | | Publication date (day/month/year) |
|---|---|---|---|---|---|---|---|
| CN | 105743509 | A | 06 July 2016 | WO | 2017128763 | A1 | 03 August 2017 |
| CN | 117318728 | A | 29 December 2023 | None | | | |
| CN | 115955248 | A | 11 April 2023 | None | | | |
| JP | 2016134808 | A | 25 July 2016 | None | | | |

Form PCT/ISA/210 (patent family annex) (July 2022)